# EUROPEAN PATENT APPLICATION

(11) **EP 4 574 552 A2**
(43) Date of publication of application: **25.06.2025**
(21) Application number: 24222863.3
(22) Date of filing: 23.12.2024
(51) Int. Cl.: B60L 53/67, B60L 58/12

(54) **SYSTEM AND APPARATUS FOR LOCATING AVAILABLE CHARGERS**

(30) Priority: 21.12.2023 US 202318392321
(71) Applicant: Volvo Car Corporation, 405 31 Göteborg (SE)
(72) Inventor: CHATZIIOANNOU, Kostas, 40531 Göteborg (SE); KOPPISETTY, Ashok Chaitanya, 40531 Göteborg (SE); YANG, Xingyun, 40531 Göteborg (SE); SANCHEZ BASUALDO, Egoi, 40531 Göteborg (SE)
(74) Representative: Maiwald GmbH

(57) **Abstract**

A system is described. The system comprises: a sensor module and a control module. The control module comprises a processor and a memory. The memory comprising a sensor control module that when executed by the processor causes the processor to: determine a first state-of-charge of one or more batteries of a vehicle; determine whether the first state-of-charge is below a threshold charge level; determine one or more first geographical ranges comprising one or more first charging stations based on the first state-of-charge; determine charge consumption factors that influence charge consumption in the batteries; estimate the charge consumption based on the charge consumption factors; determine a second state-of-charge based on the charge consumption; determine one or more second geographical ranges comprising one or more second charging stations based on the second state-of-charge; and reserve one or more charging sessions with the one or more second charging stations for charging the batteries.

## Description

### FIELD OF THE INVENTION

The present disclosure relates generally to charging systems for electric vehicles. More specifically, the present disclosure relates to a system and method for locating and reserving an available charging station.

### BACKGROUND

The current charging systems are not optimum for charging and do not have an efficient reservation system. For example, when a driver wants to charge a vehicle, the driver does not know if a charger is available for charging, either for a short time or longer duration. If the charge level has dropped below a threshold, there may not be any chargers available, which could leave the driver stranded. Thus, an auto reservation system is needed to ensure that when the charge level drops below a threshold, the system automatically locates available chargers and reserves a charger.

Therefore, there is a long-felt need for a system and method for locating and reserving an available charging station.

### SUMMARY

The following presents a summary to provide a basic understanding of one or more embodiments described herein. This summary is not intended to identify key or critical elements or delineate any scope of the different embodiments and/or any scope of the claims. The sole purpose of the summary is to present some concepts in a simplified form as a prelude to the more detailed description presented herein.

In one or more embodiments described herein, systems, devices, computer-implemented methods, methods, apparatus and/or computer program products are presented that facilitate locating and reserving an available charging station.

In an aspect, a system is described. The system comprises: a sensor module; and a control module. The control module comprises a processor; and a memory communicatively coupled to the processor. The memory comprising a sensor control module that when executed by the processor causes the processor to: determine a first state-of-charge of one or more batteries associated with a vehicle; determine whether the first state-of-charge is below a threshold charge level; determine one or more first geographical ranges comprising one or more first charging stations based on the first state-of-charge; determine one or more charge consumption factors that influence charge consumption in the one or more batteries; estimate the charge consumption based on the one or more charge consumption factors; determine a second state-of-charge based on the charge consumption; determine one or more second geographical ranges comprising one or more second charging stations based on the second state-of-charge; and reserve one or more charging sessions with the one or more second charging stations for charging the one or more batteries.

In an aspect, a method comprising: determining a first state-of-charge of one or more batteries associated with a vehicle; determining whether the first state-of-charge is below a threshold charge level; determining one or more first geographical ranges comprising one or more first charging stations based on the first state-of-charge; determining one or more charge consumption factors that influences charge consumption in the one or more batteries; estimating the charge consumption based on the one or more charge consumption factors; determining a second state-of-charge based on the charge consumption; determining one or more second geographical ranges comprising one or more second charging stations based on the second state-of-charge; and reserving one or more charging sessions with the one or more second charging stations for charging the one or more batteries.

In another aspect, a non-transitory computer readable storage medium comprising a sequence of instructions, which when executed by a processor causes: determining a first state-of-charge of one or more batteries associated with a vehicle; determining whether the first state-of-charge is below a threshold charge level; determining one or more first geographical ranges comprising one or more first charging stations based on the first state-of-charge; determining one or more charge consumption factors that influences charge consumption in the one or more batteries; estimating the charge consumption based on the one or more charge consumption factors; determining a second state-of-charge based on the charge consumption; determining one or more second geographical ranges comprising one or more second charging stations based on the second state-of-charge; and reserving one or more charging sessions with the one or more second charging stations for charging the one or more batteries.

The methods and systems disclosed herein may be implemented in any means for achieving various aspects and may be executed in a form of a non-transitory machine-readable medium embodying a set of instructions that, when executed by a machine, causes the machine to perform any of the operations disclosed herein. Other features will be apparent from the accompanying drawings and from the detailed description that follows.

### BRIEF DESCRIPTION OF THE FIGURES

These and other aspects of the present disclosure will now be described in more detail, with reference to the appended drawings showing exemplary embodiments, in which:
FIG. 1 illustrates a block diagram of a system, according to one or more embodiments.
FIG. 2 illustrates a method of reserving charging sessions, according to one or more embodiments.
FIG. 3 illustrates a non-transitory computer readable storage medium, according to one or more embodiments.
FIG. 4 illustrates a block diagram for charging a vehicle, according to one or more embodiments.
FIG. 5 illustrates a battery pack comprising an individual battery, according to one or more embodiments.
FIG. 6 illustrates a battery pack comprising a plurality of batteries, according to one or more embodiments.
FIG. 7 schematically shows a battery pack comprising a battery and a battery management system, according to one or more embodiments.
FIG. 8a illustrates one or more first geographical ranges, according to one or more embodiments.
FIG. 8b illustrates one or more second geographical ranges, according to one or more embodiments.
FIG. 9a shows complete overlapping of a first geographical range and a second geographical range, according to one or more embodiments.
FIG. 9b shows the second geographical range covering a portion of the first geographical range, according to one or more embodiments.
FIG. 9c shows the second geographical range and the first geographical range that are different from each other, according to one or more embodiments.
FIG. 10 shows a schematic diagram of a charging station, according to one or more embodiments.
FIG. 11 illustrates a message communicated to the charging station as described in FIG. 1, according to one or more embodiments.
FIG. 12 illustrates a system of auto connection and disconnection from a charging station, according to one or more embodiments.
FIG. 13 illustrates a method of auto connection and disconnection from a charging station, according to one or more embodiments.
FIG. 14 illustrates a non-transitory computer readable storage medium, according to one or more embodiments.
FIG. 15 illustrates a robotic arm plugging and unplugging a charger from a charging port of the vehicle, according to one or more embodiments.
FIG. 16a illustrates a first message, according to one or more embodiments.
FIG. 16b illustrates a fourth message, according to one or more embodiments.
FIG. 17a illustrates a second message, according to one or more embodiments.
FIG. 17b illustrates a third message, according to one or more embodiments.
FIG. 18 illustrates a scanning of a vehicle, according to one or more embodiments. In an embodiment, the vehicle is approaching the reserved charging station.
FIG. 19 illustrates a vehicle that automatically connects and disconnects from a charging station, according to one or more embodiments.
FIG. 20 illustrates a method, according to one or more embodiments.
FIG. 21 illustrates a non-transitory computer readable storage medium, according to one or more embodiments.
FIG. 22 illustrates a system that automatically locates available chargers due to a blocked parking spot, according to one or more embodiments.
FIG. 23 illustrates a method, according to one or more embodiments.
FIG. 24 illustrates a non-transitory computer readable storage medium, according to one or more embodiments.
FIG. 25 illustrates a first message described in FIG. 22, according to one or more embodiments.
FIG. 26 illustrates determination of a subsequent charging station, according to one or more embodiments.
FIG. 27 illustrates determination of one or more zones comprising charging stations, according to one or more embodiments.
FIG. 28 illustrates providing one or more routes to the reserved charging station, according to one or more embodiments.
FIG. 29 illustrates providing one or more routes to the subsequent charging station, according to one or more embodiments.
FIG. 30A shows a structure of the neural network / machine learning model with a feedback loop.
FIG. 30B shows a structure of the neural network / machine learning model with reinforcement learning.

Other features of the present embodiments will be apparent from the accompanying drawings and from the detailed description that follows.

### DETAILED DESCRIPTION

For simplicity and clarity of illustration, the figures illustrate the general manner of construction. The description and figures may omit the descriptions and details of well-known features and techniques to avoid unnecessarily obscuring the present disclosure. The figures exaggerate the dimensions of some of the elements relative to other elements to help improve understanding of embodiments of the present disclosure. The same reference numeral in different figures denotes the same element.

Although the detailed description herein contains many specifics for the purpose of illustration, a person of ordinary skill in the art will appreciate that many variations and alterations to the details are considered to be included herein.

Accordingly, the embodiments herein are without any loss of generality to, and without imposing limitations upon, any claims set forth. The terminology used herein is for the purpose of describing particular embodiments only and is not limiting. Unless defined otherwise, all technical and scientific terms used herein have the same meaning as commonly understood by one with ordinary skill in the art to which this disclosure belongs.

Unless defined otherwise, all technical and scientific terms used herein have the same meaning as commonly understood by one with ordinary skill in the art.

As used herein, the articles "a" and "an" used herein refer to one or to more than one (i.e., to at least one) of the grammatical object of the article. By way of example, "an element" means one element or more than one element. Moreover, usage of articles "a" and "an" in the subject specification and annexed drawings construe to mean "one or more" unless specified otherwise or clear from context to mean a singular form.

As used herein, the terms "example" and/or "exemplary" mean serving as an example, instance, or illustration. For the avoidance of doubt, such examples do not limit the herein described subject matter. In addition, any aspect or design described herein as an "example" and/or "exemplary" is not necessarily preferred or advantageous over other aspects or designs, nor does it preclude equivalent exemplary structures and techniques known to those of ordinary skill in the art.

As used herein, the terms "first," "second," "third," and the like in the description and in the claims, if any, distinguish between similar elements and do not necessarily describe a particular sequence or chronological order. The terms are interchangeable under appropriate circumstances such that the embodiments herein are, for example, capable of operation in sequences other than those illustrated or otherwise described herein. Furthermore, the terms "include," "have," and any variations thereof, cover a non-exclusive inclusion such that a process, method, system, article, device, or apparatus that comprises a list of elements is not necessarily limiting to those elements, but may include other elements not expressly listed or inherent to such process, method, system, article, device, or apparatus.

As used herein, the terms "left," "right," "front," "back," "top," "bottom," "over," "under" and the like in the description and in the claims, if any, are for descriptive purposes and not necessarily for describing permanent relative positions. The terms so used are interchangeable under appropriate circumstances such that the embodiments of the apparatus, methods, and/or articles of manufacture described herein are, for example, capable of operation in other orientations than those illustrated or otherwise described herein.

No element act, or instruction used herein is critical or essential unless explicitly described as such. Furthermore, the term "set" includes items (e.g., related items, unrelated items, a combination of related items and unrelated items, etc.) and may be interchangeable with "one or more". Where only one item is intended, the term "one" or similar language is used. Also, the terms "has," "have," "having," or the like are open-ended terms. Further, the phrase "based on" means "based, at least in part, on" unless explicitly stated otherwise.

As used herein, the terms "system," "device," "unit," and/or "module" refer to a different component, component portion, or component of the various levels of the order. However, other expressions that achieve the same purpose may replace the terms.

As used herein, the terms "couple," "coupled," "couples," "coupling," and the like refer to connecting two or more elements mechanically, electrically, and/or otherwise. Two or more electrical elements may be electrically coupled together, but not mechanically or otherwise coupled together. Coupling may be for any length of time, e.g., permanent, or semi-permanent or only for an instant. "Electrical coupling" includes electrical coupling of all types. The absence of the word "removably," "removable," and the like, near the word "coupled" and the like does not mean that the coupling, etc., in question is or is not removable.

As used herein, the term "or" means an inclusive "or" rather than an exclusive "or." That is, unless specified otherwise, or clear from context. "X employs A or B" means any of the natural inclusive permutations. That is, if X employs A; X employs B; or X employs both A and B, then "X employs A or B" is satisfied under any of the foregoing instances.

As used herein, two or more elements or modules are "integral" or "integrated" if they operate functionally together. Two or more elements are "non-integral" if each element can operate functionally independently.

As used herein, the term "real-time" refers to operations conducted as soon as practically possible upon occurrence of a triggering event. A triggering event can include receipt of data necessary to execute a task or to otherwise process information. Because of delays inherent in transmission and/or in computing speeds, the term "real-time" encompasses operations that occur in "near" real-time or somewhat delayed from a triggering event. In a number of embodiments, "real-time" can mean real-time less a time delay for processing (e.g., determining) and/or transmitting data. The particular time delay can vary depending on the type and/or amount of the data, the processing speeds of the hardware, the transmission capability of the communication hardware, the transmission distance, etc. However, in many embodiments, the time delay can be less than approximately one second, two seconds, five seconds, or ten seconds.

As used herein, the term "approximately" can mean within a specified or unspecified range of the specified or unspecified stated value. In some embodiments, "approximately" can mean within plus or minus ten percent of the stated value. In other embodiments, "approximately" can mean within plus or minus five percent of the stated value. In further embodiments, "approximately" can mean within plus or minus three percent of the stated value. In yet other embodiments, "approximately" can mean within plus or minus one percent of the stated value.

Digital electronic circuitry, or in computer software, firmware, or hardware, including the structures disclosed in this specification and their structural equivalents, or in combinations of one or more of them may realize the implementations and all of the functional operations described in this specification. Implementations may be as one or more computer program products, i.e., one or more modules of computer program instructions encoded on a computer-readable medium for execution by, or to control the operation of, data processing apparatus. The computer-readable medium may be a machine-readable storage device, a machine-readable storage substrate, a memory device, a composition of matter affecting a machine-readable propagated signal, or a combination of one or more of them. The term "computing system" encompasses all apparatus, devices, and machines for processing data, including by way of example, a programmable processor, a computer, or multiple processors or computers. The apparatus may include, in addition to hardware, code that creates an execution environment for the computer program in question, e.g., code that constitutes processor firmware, a protocol stack, a database management system, an operating system, or a combination of one or more of them. A propagated signal is an artificially generated signal (e.g., a machine-generated electrical, optical, or electromagnetic signal) that encodes information for transmission to a suitable receiver apparatus.

The actual specialized control hardware or software code used to implement these systems and/or methods is not limiting to the implementations. Thus, any software and any hardware can implement the systems and/or methods based on the description herein without reference to specific software code.

A computer program (also known as a program, software, software application, script, or code) is written in any appropriate form of programming language, including compiled or interpreted languages. Any appropriate form, including a standalone program or a module, component, subroutine, or other unit suitable for use in a computing environment may deploy it. A computer program does not necessarily correspond to a file in a file system. A program may be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program may execute on one computer or on multiple computers that are located at one site or distributed across multiple sites and interconnected by a communication network.

One or more programmable processors, executing one or more computer programs to perform functions by operating on input data and generating output, perform the processes and logic flows described in this specification. The processes and logic flows may also be performed by, and apparatus may also be implemented as, special purpose logic circuitry, for example, without limitation, a Field Programmable Gate Array (FPGA), an Application Specific Integrated Circuit (ASIC), Application Specific Standard Products (ASSPs), System-On-a-Chip (SOC) systems, Complex Programmable Logic Devices (CPLDs), etc.

Processors suitable for the execution of a computer program include, by way of example, both general and special purpose microprocessors, and any one or more processors of any appropriate kind of a digital computer. A processor will receive instructions and data from a read-only memory or a random-access memory or both. Elements of a computer can include a processor for performing instructions and one or more memory devices for storing instructions and data. A computer will also include, or is operatively coupled to receive data, transfer data or both, to/from one or more mass storage devices for storing data e.g., magnetic disks, magneto optical disks, optical disks, or solid-state disks. However, a computer need not have such devices. Moreover, another device, e.g., a mobile telephone, a personal digital assistant (PDA), a mobile audio player, a Global Positioning System (GPS) receiver, etc., may embed a computer. Computer-readable media suitable for storing computer program instructions and data include all forms of non-volatile memory, media and memory devices, including, by way of example, semiconductor memory devices (e.g., Erasable Programmable Read-Only Memory (EPROM), Electronically Erasable Programmable Read-Only Memory (EEPROM), and flash memory devices), magnetic disks (e.g., internal hard disks or removable disks), magneto optical disks (e.g. Compact Disc Read-Only Memory (CD ROM) disks, Digital Versatile Disk-Read-Only Memory (DVD-ROM) disks) and solid-state disks. Special purpose logic circuitry may supplement or incorporate the processor and the memory.

To provide for interaction with a user, a computer may have a display device, e.g., a Cathode Ray Tube (CRT) or Liquid Crystal Display (LCD) monitor, for displaying information to the user, and a keyboard and a pointing device, e.g., a mouse or a trackball, by which the user may provide input to the computer. Other kinds of devices provide for interaction with a user as well. For example, feedback to the user may be any appropriate form of sensory feedback, e.g., visual feedback, auditory feedback, or tactile feedback; and a computer may receive input from the user in any appropriate form, including acoustic, speech, or tactile input.

A computing system that includes a back-end component, e.g., a data server, or that includes a middleware component, e.g., an application server, or that includes a front-end component, e.g., a client computer having a graphical user interface or a Web browser through which a user may interact with an implementation, or any appropriate combination of one or more such back-end, middleware, or front-end components, may realize implementations described herein. Any appropriate form or medium of digital data communication, e.g., a communication network may interconnect the components of the system. Examples of communication networks include a Local Area Network (LAN) and a Wide Area Network (WAN), e.g., Intranet and Internet.

The computing system may include clients and servers. A client and server are remote from each other and typically interact through a communication network. The relationship of the client and server arises by virtue of computer programs running on the respective computers and having a client-server relationship to each other.

Embodiments may comprise or utilize a special purpose or general purpose computer including computer hardware. Embodiments within the scope of the present invention may also include physical and other computer-readable media for carrying or storing computer-executable instructions and/or data structures. Such computer-readable media can be any media accessible by a general purpose or special purpose computer system. Computer-readable media that store computer-executable instructions are physical storage media. Computer-readable media that carry computer-executable instructions are transmission media. Thus, by way of example and not limitation, embodiments of the invention can comprise at least two distinct kinds of computer-readable media: physical computer-readable storage media and transmission computer-readable media.

Although the present embodiments described herein are with reference to specific example embodiments it will be evident that various modifications and changes may be made to these embodiments without departing from the broader spirit and scope of the various embodiments. For example, hardware circuitry (e.g., Complementary Metal Oxide Semiconductor (CMOS) based logic circuitry), firmware, software (e.g., embodied in a non-transitory machine-readable medium), or any combination of hardware, firmware, and software may enable and operate the various devices, units, and modules described herein. For example, transistors, logic gates, and electrical circuits (e.g., Application Specific Integrated Circuit (ASIC) and/or Digital Signal Processor (DSP) circuit) may embody the various electrical structures and methods.

In addition, a non-transitory machine-readable medium and/or a system may embody the various operations, processes, and methods disclosed herein. Accordingly, the specification and drawings are illustrative rather than restrictive.

Physical computer-readable storage media includes RAM, ROM, EEPROM, CD-ROM or other optical disk storage (such as CDs, DVDs, etc.), magnetic disk storage or other magnetic storage devices, solid-state disks or any other medium. They store desired program code in the form of computer-executable instructions or data structures which can be accessed by a general purpose or special purpose computer.

As used herein, the term "network" refers to one or more data links that enable the transport of electronic data between computer systems and/or modules and/or other electronic devices. When a network or another communications connection (either hardwired, wireless, or a combination of hardwired or wireless) transfers or provides information to a computer, the computer properly views the connection as a transmission medium. A general purpose or special purpose computer access transmission media that can include a network and/or data links which carry desired program code in the form of computer-executable instructions or data structures. The scope of computer-readable media includes combinations of the above, that enable the transport of electronic data between computer systems and/or modules and/or other electronic devices. Further, upon reaching various computer system components, program code in the form of computer-executable instructions or data structures can be transferred automatically from transmission computer-readable media to physical computer-readable storage media (or vice versa). For example, computer-executable instructions or data structures received over a network or data link can be buffered in RAM within a Network Interface Module (NIC), and then eventually transferred to computer system RAM and/or to less volatile computer-readable physical storage media at a computer system. Thus, computer system components that also (or even primarily) utilize transmission media may include computer-readable physical storage media.

Computer-executable instructions comprise, for example, instructions and data which cause a general purpose computer, special purpose computer, or special purpose processing device to perform a certain function or group of functions. The computer-executable instructions may be, for example, binary, intermediate format instructions such as assembly language, or even source code. Although the subject matter herein described is in a language specific to structural features and/or methodological acts, the described features or acts described do not limit the subject matter defined in the claims. Rather, the herein described features and acts are example forms of implementing the claims.

While this specification contains many specifics, these do not construe as limitations on the scope of the disclosure or of the claims, but as descriptions of features specific to particular implementations. A single implementation may implement certain features described in this specification in the context of separate implementations. Conversely, multiple implementations separately or in any suitable sub-combination may implement various features described herein in the context of a single implementation. Moreover, although features described herein as acting in certain combinations and even initially claimed as such, one or more features from a claimed combination may in some cases be excised from the combination, and the claimed combination may be directed to a sub-combination or variation of a sub-combination.

Similarly, while operations depicted herein in the drawings in a particular order to achieve desired results, this should not be understood as requiring that such operations be performed in the particular order shown or in sequential order or that all illustrated operations be performed, to achieve desirable results. In certain circumstances, multitasking and parallel processing may be advantageous. Moreover, the separation of various system components in the implementations should not be understood as requiring such separation in all implementations, and it should be understood that the described program components and systems may be integrated together in a single software product or packaged into multiple software products.

Even though particular combinations of features are recited in the claims and/or disclosed in the specification, these combinations are not intended to limit the disclosure of possible implementations. Other implementations are within the scope of the claims. For example, the actions recited in the claims may be performed in a different order and still achieve desirable results. In fact, many of these features may be combined in ways not specifically recited in the claims and/or disclosed in the specification. Although each dependent claim may directly depend on only one claim, the disclosure of possible implementations includes each dependent claim in combination with every other claim in the claim set.

Further, a computer system including one or more processors and computer-readable media such as computer memory may practice the methods. In particular, one or more processors execute computer-executable instructions, stored in the computer memory, to perform various functions such as the acts recited in the embodiments.

Those skilled in the art will appreciate that the invention may be practiced in network computing environments with many types of computer system configurations including personal computers, desktop computers, laptop computers, message processors, hand-held devices, multiprocessor systems, microprocessor-based or programmable consumer electronics, network PCs, minicomputers, mainframe computers, mobile telephones, PDAs, pagers, routers, switches, etc. Distributed system environments where local and remote computer systems, which are linked (either by hardwired data links, wireless data links, or by a combination of hardwired and wireless data links) through a network, both perform tasks may also practice the invention. In a distributed system environment, program modules may be located in both local and remote memory storage devices.

The following terms and phrases, unless otherwise indicated, shall have the following meanings.

As used herein, the term "sensor module" refers to a unit that contains components or circuits in addition to the sensors. The additional components or circuits make the sensor easy to use. The sensor module may be an integrated circuit comprising additional components and sensors adaptable for an application. The sensor module may comprise one or more sensors that operate functionally together. For example, the one or more cameras and the one or more sensors within the sensor module are integrated with one another to determine charge consumption factors. The sensors within the sensor module operate in an integrated manner to monitor the environmental conditions, external surroundings, etc., to estimate and monitor the charge consumption.

In an example, the sensor module comprises at least one of one or more weight sensors, one or more load cells, one or more infrared sensors, one or more proximity sensors, one or more ultrasonic sensors, one or more light detection and ranging (LIDAR) sensors, one or more voltage sensors, one or more temperature sensors, one or more light sensors, one or more capacitive load cells, and one or more accelerometers.

As used herein, the term "control module" refers to a unit or a system that makes all the important decisions about the way that it is run. The term "control module" means a component designed to ensure the combined functioning of all components of the vehicle.

As used herein, the term "charging system" as used herein refers to an apparatus that is capable of charging a battery pack. The battery pack may comprise one or more batteries. The charging system is capable of charging the battery pack. The charging system is also capable of monitoring and controlling the battery pack. The charging system is also capable of calculating and monitoring battery parameters (e.g., battery impedance, battery resistance, battery temperature, state-of-charge, state-of-health, etc.). The charging system is communicatively coupled to a vehicle computer system. The charging system is also communicatively coupled to the charging station.

As used herein, the term "electric vehicle (EV)" refers to an automobile, as defined in 49 CFR 523.3, intended for highway use, powered by an electric motor that draws current from an on-vehicle energy storage device, such as a battery, which is rechargeable from an off vehicle source, such as residential or public electric service or an on-vehicle fuel powered generator. The EV may be two or more wheeled vehicles manufactured for use primarily on public streets, roads. The EV may be referred to as an electric car, an electric automobile, an electric road vehicle (ERV), a plug-in vehicle (PV), a plug-in vehicle (xEV), etc., and the xEV may be classified into a plug-in all-electric vehicle (BEV), a battery electric vehicle, a plug-in electric vehicle (PEV), a hybrid electric vehicle (HEV), a hybrid plug-in electric vehicle (HPEV), a plug-in hybrid electric vehicle (PHEV), etc.

As used herein, the term "plug-in electric vehicle (PEV)" refers to an Electric Vehicle that recharges the on-vehicle primary battery by connecting to the power grid.

As used herein, the term "plug-in vehicle (PV)" refers to an electric vehicle rechargeable through wireless charging from an electric vehicle supply equipment (EVSE) without using a physical plug or a physical socket.

As used herein, the term "heavy duty vehicle (HD Vehicle)" refers to any four- or more wheeled vehicle as defined in 49 CFR 523.6 or 49 CFR 37.3 (bus).

As used herein, the term "light duty plug-in electric vehicle" refers to a three or four-wheeled vehicle propelled by an electric motor drawing current from a rechargeable storage battery or other energy devices for use primarily on public streets, roads and highways and rated at less than 4, 545 kg gross vehicle weight.

As used herein, the term "state-of-health (SoH)" refers to a figure of merit of the condition of a battery pack, compared to its ideal conditions. The state-of-health (SoH) of a battery pack describes the difference between a battery pack being studied and a fresh battery pack and considers cell aging. The SoH is defined as the ratio of the maximum battery charge to its rated capacity. It may be expressed in percentage form. The battery pack may comprise one or more batteries.

As used herein, the term "charging station" refers to a device that includes at least one docking terminal with a charger for charging a battery pack. The battery pack may comprise one or more batteries. The term "charging station," as used further refers to an apparatus that can function as a source of power for charging the battery pack of an electric vehicle including facilitating data communications between the electric vehicle and the charging station. The communications may be established through a wired connection or a wireless connection. The charging station is also capable of charging the electric vehicle either through a wired connection or a wireless connection.

As used herein, the term "charging session" refers to an event starting when a user or a vehicle initiates a refueling event (e.g., charging event) and stops when a user or a vehicle ends a refueling event (e.g., charging event). The charging session further refers to a charging occurrence for a single EV, during which a certain amount of energy is transmitted to the EV, measured in duration according to the time of the EV's physical plug-in to the EVSE to the time of the EV's physical plug-out from the EVSE.

As used herein, the term "optimized route" refers to a route to the intended destination covering shortest distance through which the vehicle can travel with lesser traffic condition and in lesser time. The optimized route refers to a route through which the vehicle travels with fuel, battery charge, efficiency.

As used herein, the term "battery pack" as used herein refers to a set of any number of identical batteries or individual cells of a battery. The "battery pack" may also refer to a set of non-identical batteries. The batteries in the battery pack may be configured in a series, parallel or a mixture of both to deliver the desired voltage, capacity, and/or power density.

As used herein, the term "control unit" or "control module" or "electronic control unit" refers to a functional unit in a computer system that controls one or more units of the peripheral equipment. For example, it may be a component of a charging system that provides instructions or signals to the charger unit to charge the battery pack as per the charging requirement.

As used herein, the term "module" refers to any hardware, software, firmware, electronic control component, processing logic, and/or processor device, individually or in any combination, including without limitation: application specific integrated circuit (ASIC), a field-programmable gate-array (FPGA), an electronic circuit, a processor (shared, dedicated, or group) and memory that executes one or more software or firmware programs, a combinational logic circuit, and/or other suitable components that provide the described functionality.

As used herein, the term "vehicle computer system" refers to an embedded system in automotive electronics that controls one or more of the electrical systems or subsystems in a vehicle. The computer executes a large number of different software functions in the powertrain, chassis, driver assistance, and infotainment domains, etc., that are executed on separate control units. The vehicle computer system may be communicatively coupled with an external device of a user. The vehicle computer system may also be communicatively coupled with the charging station.

As used herein, the term "electronic control unit" (ECU), also known as an "electronic control module" (ECM), is a system that controls one or more subsystems. An ECU may be installed in a car or other motor vehicle. It may refer to many ECUs, and can include but not limited to, Engine Control Module (ECM), Powertrain Control Module (PCM), Transmission Control Module (TCM), Brake Control Module (BCM) or Electronic Brake Control Module (EBCM), Central Control Module (CCM), Central Timing Module (CTM), General Electronic Module (GEM), Body Control Module (BCM), and Suspension Control Module (SCM). ECUs together are sometimes referred to collectively as the vehicles' computer or vehicles' central computer and may include separate computers. In an example, the electronic control unit can be embedded in automotive electronics. In another example, the electronic control unit is wirelessly coupled with the automotive electronics.

As used herein, the term "infotainment system" or "infotainment unit" or "in-vehicle infotainment system" (IVI) as used herein refers to a combination of systems which are used to deliver entertainment and information. In an example, the information may be delivered to the driver and the passengers of a vehicle through audio / video interfaces, control elements like touch screen displays, button panel, voice commands, and more. Some of the main components of an in-vehicle infotainment systems are integrated head-unit, heads-up display, high-end Digital Signal Processors (DSPs), and Graphics Processing Units (GPUs) to support multiple displays, operating systems, Controller Area Network (CAN), Low-Voltage Differential Signaling (LVDS), and other network protocol support (as per the requirement), connectivity modules, automotive sensors integration, digital instrument cluster, etc.

As used herein, the term "charging sequence" refers to a charging pattern defined by the charging system or the charging station based on the battery parameters (e.g., state-of-charge, state-of health) and charging time. The charging sequence may comprise a charging level for a predefined charging time segment. The charging sequence may also comprise a charging level for a predefined portion (e.g., healthy cells, degraded cells) of the battery pack. The charging level may comprise a regular charging, a fast charging, and a trickle charging.

As used herein, the term "maximum charging" or "optimally charging" as used refers to a maximum rate at which the charging is provided to the battery pack during the charging time without damaging the battery pack.

As used herein, the term "charging time" as used herein refers to a time allotted for charging. The charging time may be provided by the user. The charging time may also be determined by the charging station or the charging system. The charging time may be split into charging time segments. Each charging time segment may correspond to a different charging level. Each charging time segment may correspond to charging the different portion of the battery pack.

As used herein, the term "state-of-charge (SoC)" refers to the level of charge of an electric battery pack relative to its capacity. The units of SoC are percentage points (0% = empty; 100% = full). An alternative form of the same measure is the depth of discharge (DoD), the inverse of SoC (100% = empty; 0% = full). SoC is normally used when discussing the current state of a battery in use, while DoD is most often seen when discussing the lifetime of the battery after repeated use.

As used herein, the term "first state-of-charge (SoC)" refers to the level of charge of an electric battery pack relative to its capacity at a specific point of time.

As used herein, the term "second state-of-charge (SoC)" refers to the level of charge of an electric battery pack relative to its capacity at a later point of time. For example, the second state-of charge (SoC) refers to the level of charge after the charge consumption based on the one or more charge consumption factors.

As used herein, the term "threshold charge level" refers to a minimum charge level of the electric battery pack (having the one or more batteries) of the vehicle necessary to operate a predefined function of the vehicle. The threshold charge level may be preset by the processor of the control module. The threshold charge level can be altered by the processor.

As used herein, the term "first geographical range" refers to a distance range, computed, based on the first state-of-charge. The first geographical range may refer to a distance range that the vehicle can travel using the first state-of-charge. The first geographical range may comprise one or more zones. The one or more zones may be contiguous. The first geographical range may comprise one or more zones surrounding the vehicle.

As used herein, the term "second geographical range" refers to a distance range, computed, based on the second state-of-charge. The second geographical range may refer to a distance range that the vehicle can travel after the charge consumption due to the one or more charge consumption factors. The second geographical range may refer to a distance range that the vehicle can travel using the second state-of-charge. The second geographical range may comprise one or more zones. The one or more zones may be contiguous. The second geographical range may comprise one or more zones surrounding the vehicle.

As used herein, the term "bidirectional communication" refers to an exchange of data between two components. In an example, the first component can be a vehicle and the second component can be an infrastructure that is enabled by a system of hardware, software, and firmware. This communication is typically wireless. In another example, the first component can be a charging system and the second component can be a charging station.

As used herein, the term "machine learning" refers to algorithms that give a computer the ability to learn without being explicitly programmed, including algorithms that learn from and make predictions about data. Machine learning algorithms include, but are not limited to, decision tree learning, artificial neural networks (ANN) (also referred to herein as a "neural net"), deep learning neural network, support vector machines, rules-based machine learning, random forest, etc. For the purposes of clarity, algorithms such as linear regression or logistic regression can also be used as part of a machine learning process. However, it is understood that using linear regression or another algorithm as part of a machine learning process is distinct from performing a statistical analysis such as regression with a spreadsheet program. The machine learning process can continually learn and adjust the classifier as new data becomes available and does not rely on explicit or rules-based programming. Statistical modelling relies on finding relationships between variables (e.g., mathematical equations) to predict an outcome. The ANN may be featured with a feedback loop to adjust the system output dynamically as it learns from the new data as it becomes available. In machine learning, backpropagation and feedback loops are used to train the AI/MI, model improving the model's accuracy and performance over time.

As used herein, the term "communication" refers to the transmission of information and/or data from one point to another. Communication may be by means of electromagnetic waves. It is also a flow of information from one point, known as the source, to another, the receiver. Communication comprises one of the following: transmitting data, instructions, and information or a combination of data, instructions, and information. Communication happens between any two communication systems or communicating units. The term "in communication with" may refer to any coupling, connection, or interaction using electrical signals to exchange information or data, using any system, hardware, software, protocol, or format, regardless of whether the exchange occurs wirelessly or over a wired connection. The term "communication" includes systems that combine other more specific types of communication, such as V2I (Vehicle-to-Infrastructure), V2I (Vehicle-to-Infrastructure), V2N (Vehicle-to-Network), V2V (Vehicle-to-Vehicle), V2P (Vehicle-to-Pedestrian), V2D (Vehicle-to-Device) and V2G (Vehicle-to-Grid) and Vehicle-to-Everything (V2X) communication. V2X communication is the transmission of information from a vehicle to any entity that may affect the vehicle, and vice versa. The main motivations for developing V2X are occupant safety, road safety, traffic efficiency and energy efficiency. Depending on the underlying technology employed, there are two types of V2X communication technologies: cellular networks and other technologies that support direct device-to-device communication (such as Dedicated Short-Range Communication (DSRC), Port Community System (PCS), Bluetooth^{®}, Wi-Fi^{®}, etc.). Further, the emergency communication apparatus is configured on a computer with the communication function and is connected for bidirectional communication with the on-vehicle emergency report apparatus by a communication line through a radio station and a communication network such as a public telephone network or by satellite communication through a communication satellite. The emergency communication apparatus is adapted to communicate, through the communication network, with communication terminals including a road management office, a police station, a fire department, and a hospital. The emergency communication apparatus can also be connected online with the communication terminals of the persons or vehicles concerned, associated with the occupant or vehicle, and the driver or vehicle receiving the service, of the emergency-reporting vehicle.

As used herein, the term "message structure" refers to a structure of a communication message when a query and fetch operation occurs. It comprises a payload and a header, where the payload includes the quantitative value of the information that is shared, and the header includes reference to the information being shared. The message structure acts as a superstructure to accommodate any sub protocol structure such as AMQP, MQTT, Zigbee, etc.

As used herein, the term "artificial intelligence unit" refers to any system that perceives its environment and takes actions that maximize its chance of achieving its goals. An artificial intelligence unit utilizes a plurality of machine learning algorithms that allow systems to automatically improve through experience.

As used herein, the term "communication system" or "communication module" as used herein refers to a system which enables the information exchange between two points. The process of transmission and reception of information is called communication. The major elements of communication include but are not limited to a transmitter of information, channel or medium of communication and a receiver of information.

As used herein, the term "artificial intelligence (AI)" refers to the intelligence demonstrated by machines, as opposed to the natural intelligence displayed by humans. AI research has been defined as any system that perceives its environment and takes actions that maximize its chance of achieving its goals. The term "artificial intelligence" is now described in terms of rationality and acting rationally, which does not limit how intelligence can be articulated.

As used herein, the term "sensor control module" refers to actuators and basic control logic that acts as either a regulating device, a state-oriented device or a combination that is operated as a single device.

As used herein, the term "charge consumption factors" refers to one or more factors that contribute to the charge consumption. The charge consumption factors may also refer to one or more factors that are responsible for the charge consumption. The charge consumption factors may be at least one of internal charge consumption factors and external charge consumption factors. The charge consumption factors may refer to factors that may lead to consumption of electric energy, charge, beyond the actual amount of available electric energy, charge (usually the available electric energy, charge, of a vehicle). The actual amount of electric energy refers to energy to operate the vehicle in a normal condition (e.g., normal environment, normal mode, etc.).

As used herein, the term "internal charge consumption factors" refers to one or more factors that are internal to the vehicle. The internal charge consumption factors may comprise at least one of a vehicle weight, a state-of-health of the one or more batteries, an occupant weight, a luggage weight, a vehicle specification, a vehicle operating mode, and a vehicle fuel operating mode.

As used herein, the term "external charge consumption factors" refers to one or more factors that are external to the vehicle. The external charge consumption factors comprise at least one of an environmental condition, a road surface condition, a distance between the one or more first charging stations and the vehicle, a traffic condition, a waiting time, and a driving pattern.

As used herein, the term "vehicle weight" refers to an actual weight of the vehicle without a load affixed onto the vehicle.

As used herein, the term "an occupant weight" refers to a weight of the one or more occupants onto the vehicle.

As used herein, the term "a luggage weight" refers to a weight of the one or more luggage loaded onto the vehicle.

As used herein, the term "vehicle specification" refers to a detailed description of the vehicle. The vehicle specification refers to information of essential details of the vehicle. The vehicle specification may comprise measurements, mechanical details, engine capabilities, vehicle operating modes, operating types, loading capabilities, vehicle fuel operating modes, etc.

As used herein, the term "vehicle operating mode" refers to a mode of operation of the vehicle. The vehicle operating mode may comprise one of an auto pilot mode, an autonomous mode, a non-autonomous mode, and a semi- autonomous mode.

As used herein, the term "vehicle fuel operating mode" refers to a fuel mode on which the vehicle is operating. The vehicle fuel operating mode comprises one of a hybrid mode, an electric mode, and a combustion fuel mode.

As used herein, the term "sudden change" refers to an unexpected change. The sudden change may also refer to an irregular change in metrics or values.

As used herein, the term "event" refers to an occurrence of something that happens. An event may be an organized and planned event. The event may also be an unorganized and unplanned event. The event may be due to weather. The event may be due to surrounding vehicles (e.g., traffic conditions, etc.). The event may be due to the result of an activity happening external to the vehicle. The event may be due to the result of an activity happening internally to the vehicle.

As used herein, the term "robotic arm" refers to a machine integrated with the charging station for plugging and/or unplugging the charger from the charging port. The robotic arm may also be a machine that is not integrated with the charging station. The robotic arm may be a foldable arm like structure.

As used herein, the term "reserved charging spot" refers to a charging spot within the charging station that is reserved for charging the vehicle. The charging station may comprise one or more charging spots. The charging spot refers to a space where the vehicle is parked and is to undergo charging from a charging unit.

As used herein, the term "reserved charging unit" refers to a charging unit within the charging station that is reserved for providing charge to the vehicle. The charging station may comprise one or more charging units. The charging unit refers to an apparatus or a system which supplies power to the vehicle via a charging port. The charging unit may charge the vehicle either wired or wirelessly.

As used herein, the term "plugging" refers to insertion of the charging cable into the charging port. The charging cable may comprise a charger plug that fits exactly into the charging port. The charger plug may comprise metal pins capable of supplying power to the vehicle for charging the battery pack.

As used herein, the term "unplugging" refers to the removal of the charging cable away from the charging port.

As used herein, the term "predefined charge" refers to a predefined amount of electric power to be supplied to the vehicle for charging the vehicle.

As used herein, the term "predefined charge duration" refers to a predefined time for which the predefined amount of electric power is supplied to the vehicle for charging the vehicle.

As used herein, the term "zone" refers to one or more regions around or surrounding or along the direction of the vehicle. The zone encompasses one or more charging stations. The zone comprises a predefined area. The one or more regions may be contiguous. The one or more regions may be non-contiguous.

As used herein, the term "real-time location" refers to a current location of any object (e.g., vehicle) at this point of time. The real-time location refers to the location of the vehicle in real time.

As used herein "itinerary" refers to a travel plan of a user. The itinerary comprises scheduled events, their locations, duration, time, date, etc. In an embodiment, "itinerary" refers to a trip to work, trips to a doctor, trips to a grocery store, and the like. The itineraries may also include other infrequently used itineraries, such as vacation trips, extended travel, short term trips, quick trips, and the like. The itineraries may be divided into a predicted departure time, departure point, a start time, a destination, and an end time.. The itinerary may also include intermediate waypoints that further define the route. The itinerary may include, without limitation, departure point, departure time, destination, intended route, and optional intermediate waypoints.

As used herein, the term "occupancy status" refers to information regarding whether the charging station or the respective or reserved charging unit is occupied or not. The occupancy status may be one of "available" and "occupied". The occupancy status is indicated as "occupied" when there is another vehicle blocking or obstructing the charging station or the reserved charging unit. The occupancy status may also be indicated as "occupied" when there is no charging session for the vehicle reserved with the charging station. The occupancy status is indicated as "available" when there is not any other vehicle blocking or obstructing the charging station. The occupancy status may also be indicated as "available" when there is a reserved charging session waiting for the reserved vehicle at the reserved charging unit.

As used herein, the term "operational status" refers to information regarding whether the charging station is in operation of charging the vehicle or whether the charging station is available for charging the vehicle. The operational status may be one of "available" and "occupied". The operational status is indicated as "occupied" when the charging station is in the operation of charging a vehicle. The operational status may also be indicated as "occupied" when there is no charging session for the vehicle reserved with the charging station. The operational status is indicated as "available" when the charging station is ready for charging a vehicle. The operational status may also be indicated as "available" when there is a charging session for the vehicle reserved with the charging station.

As used herein, the term "occupant" refers to a person seated in the vehicle. The occupant is one of a child, a kid, an adult, and an aged person. The occupant may be a driver, a passenger, etc. The occupant may exit from the vehicle. In the event of the occupant exiting from the vehicle, the vehicle may operate in auto-pilot mode.

As used herein, the term "reserved charging session" refers to an event scheduled for charging the vehicle with the respective charging unit in the charging station.

As used herein, the term "content" refers to an object, a data, a visual representation, information, etc. The content may comprise meaningful information. The content may also comprise random information that is meaningless.

As used herein, the term "vehicle identification number" refers to an identifying code for a specific automobile. The vehicle identification number (VIN) is a unique code, including a serial number, used to identify individual motor vehicles.

As used herein, the term "vehicle type" refers to a type to which the vehicle is categorized. The vehicle type comprises one of an autonomous vehicle, a non-autonomous vehicle and a semi-autonomous vehicle.

As used herein, the term "scheduled time period" refers to a time period for which an event is scheduled to be executed. For example, the term "scheduled time period" refers to the scheduled times, start time and end time, of an event for which the charging is to be executed.

As used herein, the term "coordinates" refers to a set of values that shows an exact position.

As used herein, the term "predefined proximity" refers to a predefined distance between the two objects (e.g., the vehicle and charging station).

As used herein, the term "status inquiry" refers to a message that inquires at least one of an operational status and an occupancy status of the charging station. The vehicle may receive the operational status and the occupancy status from the charging station via a message or any other format in response to the status inquiry message.

As used herein, the term "first route" refers to a route that guides/leads the vehicle to the reserved charging station.

As used herein, the term "second route" refers to a route that guides/leads the vehicle to the subsequent charging station.

As used herein, the term "reserved charging station" refers to a charging station that is reserved for charging the vehicle.

As used herein, the term "subsequent charging station" refers to a charging station that is subsequent to the reserved charging station. The subsequent charging station is the next closest charging station. The subsequent charging station may be inquired and/or reserved when at least one of the first operational status and the first occupancy status is received as occupied.

As used herein, the term "Cryptographic protocol" is also known as security protocol or encryption protocol. It is an abstract or concrete protocol that performs a security-related function and applies cryptographic methods often as sequences of cryptographic primitives. A protocol describes usage of the algorithms. A sufficiently detailed protocol includes details about data structures and representations, to implement multiple, interoperable versions of a program. Cryptographic protocols are widely used for secure application-level data transport. A cryptographic protocol usually incorporates at least some of these aspects: key agreement or establishment, entity authentication, symmetric encryption, and message authentication, secured application-level data transport, non-repudiation methods, secret sharing methods, and secure multi-party computation. Hashing algorithms may be used to verify the integrity of data. Secure Socket Layer (SSL) and Transport Layer Security (TLS), the successor to SSL, are cryptographic protocols that may be used by networking switches to secure data communications over a network.

Secure application-level data transport widely uses cryptographic protocols. A cryptographic protocol usually incorporates at least some of these aspects: key agreement or establishment, entity authentication, symmetric encryption, and message authentication material construction, secured application-level data transport, non-repudiation methods, secret sharing methods, and secure multi-party computation.

Networking switches use cryptographic protocols, like Secure Socket Layer (SSL) and Transport Layer Security (TLS), the successor to SSL, to secure data communications over a wireless network.

As used herein, the term "Unauthorized access" is when someone gains access to a website, program, server, service, or other system using someone else's account or other methods. For example, if someone kept guessing a password or username for an account that was not theirs until they gained access, it is considered unauthorized access.

As used herein, the term "IoT" stands for Internet of Things which describes the network of physical objects "things" or objects embedded with sensors, software, and other technologies for the purpose of connecting and exchanging data with other devices and systems over the internet.

As used herein "Machine learning" refers to algorithms that give a computer the ability to learn without being explicitly programmed, including algorithms that learn from and make predictions about data. Machine learning techniques include, but are not limited to, and support vector machine, artificial neural network (ANN) (also referred to herein as a "neural net"), deep learning neural network, logistic regression, discriminant analysis, random forest, linear regression, rules-based machine learning, Naive Bayes, nearest neighbor, decision tree, decision tree learning, and hidden Markov, etc. For the purposes of clarity, algorithms such as linear regression or logistic regression can also be used as part of a machine learning process. However, it is understood that using linear regression or another algorithm as part of a machine learning process is distinct from performing a statistical analysis such as regression with a spreadsheet program. The machine learning process can continually learn and adjust the classifier as new data becomes available and does not rely on explicit or rules-based programming. The ANN may be featured with a feedback loop to adjust the system output dynamically as it learns from the new data as it becomes available. In machine learning, backpropagation and feedback loops are used to train the AI/ML model improving the model's accuracy and performance over time.

As used herein, the term "Dashboard" is a type of interface that visualizes particular Key Performance Indicators (KPIs) for a specific goal or process. It is based on data visualization and infographics.

As used herein, a "Database" is a collection of organized information so that it can be easily accessed, managed, and updated. Computer databases typically contain aggregations of data records or files.

As used herein, the term "Data set" (or "Dataset") is a collection of data. In the case of tabular data, a data set corresponds to one or more database tables, where every column of a table represents a particular variable, and each row corresponds to a given record of the data set in question. The data set lists values for each of the variables, such as height and weight of an object, for each member of the data set. Each value is known as a datum. Data sets can also consist of a collection of documents or files.

As used herein, a "Sensor" is a device that detects and measures physical properties from the surrounding environment and converts this information into electrical or digital signals that can be interpreted by either a human or a machine for further processing. Sensors play a crucial role in collecting data for various applications across industries. Sensors may be made of electronic, mechanical, chemical, or other engineering components. Most sensors are electronic (the data is converted into electronic data), but some are simpler, such as a glass thermometer, which presents visual data. Examples include sensors to measure temperature, pressure, humidity, proximity, light, acceleration, orientation etc. In an embodiment, sensors may be removably or fixedly installed within the vehicle and may be disposed in various arrangements to provide information to the autonomous operation features. The sensors may include one or more of a GPS unit, a radar unit, a LIDAR unit, an ultrasonic sensor, an infrared sensor, an inductance sensor, a camera, an accelerometer, a tachometer, a tension sensor, or a speedometer. Some of the sensors (e.g., radar, LIDAR, or camera units) may actively or passively scan the interior of the vehicle for the presence of occupants (e.g., child, adult, kids, passenger, driver, etc.) to determine occupant weight and vehicle weight.

The term "vehicle" as used herein refers to a thing used for transporting people or goods. Automobiles, cars, trucks, buses, etc., are examples of vehicles.

The term "electronic control unit" (ECU), also known as an "electronic control module" (ECM), is usually a module that controls one or more subsystems. Herein, an ECU may be installed in a car or other motor vehicle. It may refer to many ECUs, and can include but not limited to, Engine Control Module (ECM), Powertrain Control Module (PCM), Transmission Control Module (TCM), Brake Control Module (BCM) or Electronic Brake Control Module (EBCM), Central Control Module (CCM), Central Timing Module (CTM), General Electronic Module (GEM), Body Control Module (BCM), and Suspension Control Module (SCM). ECUs together are sometimes referred to collectively as the vehicles' computer or vehicles' central computer and may include separate computers. In an example, the electronic control unit can be an embedded system in automotive electronics. In another example, the electronic control unit is wirelessly coupled with the automotive electronics.

The terms "non-transitory computer-readable medium" and "computer-readable medium" include a single medium or multiple media such as a centralized or distributed database, and/or associated caches and servers that store one or more sets of instructions. Further, the terms "non-transitory computer-readable medium" and "computer-readable medium" include any tangible medium that is capable of storing, encoding, or carrying a set of instructions for execution by a processor that, for example, when executed, cause a system to perform any one or more of the methods or operations disclosed herein. As used herein, the term "computer readable medium" is expressly defined to include any type of computer readable storage device and/or storage disk and to exclude propagating signals.

The term "Vehicle Data bus" as used herein represents the interface to the vehicle data bus (e.g., CAN, LIN, Ethernet/IP, FlexRay, and MOST) that may enable communication between the Vehicle on-board equipment (OBE) and other vehicle systems to support connected vehicle applications.

The term, "handshaking" refers to an exchange of predetermined signals between agents connected by a communications channel to assure each that it is connected to the other (and not to an imposter). This may also include the use of passwords and codes by an operator. Handshaking signals are transmitted back and forth over a communications network to establish a valid connection between two stations. A hardware handshake uses dedicated wires such as the request-to-send (RTS) and clear-to-send (CTS) lines in an RS-232 serial transmission. A software handshake sends codes such as "synchronize" (SYN) and "acknowledge" (ACK) in a TCP/IP transmission.

The term "infotainment system" or "in-vehicle infotainment system" (IVI) as used herein refers to a combination of vehicle systems which are used to deliver entertainment and information. In an example, the information may be delivered to the driver and the passengers of a vehicle/occupants through audio / video interfaces, control elements like touch screen displays, button panel, voice commands, and more. Some of the main components of an in-vehicle infotainment systems are integrated head-unit, heads-up display, high-end Digital Signal Processors (DSPs), and Graphics Processing Units (GPUs) to support multiple displays, operating systems, Controller Area Network (CAN), Low-Voltage Differential Signaling (LVDS), and other network protocol support (as per the requirement), connectivity modules, automotive sensors integration, digital instrument cluster, etc.

The term "autonomous mode" as used herein refers to a vehicle operating mode which is independent and unsupervised.

The term "autonomous communication" as used herein comprises communication over a period with minimal supervision under different scenarios and is not solely or completely based on pre-coded scenarios or pre-coded rules or a predefined protocol. Autonomous communication, in general, happens in an independent and an unsupervised manner. In an embodiment, a communication module is enabled for autonomous communication.

The term "communication protocol" as used herein refers to standardized communication between any two systems. An example of a communication protocol is a DSRC protocol. The DSRC protocol uses a specific frequency band (e.g., 5.9 GHz) and specific message formats (such as the Basic Safety Message, Signal Phase and Timing, and Roadside Alert) to enable communications between vehicles and infrastructure components, such as traffic signals and roadside sensors. DSRC is a standardized protocol, and its specifications are maintained by various organizations, including the IEEE and SAE International.

The term "alert" or "alert signal" refers to a communication to attract attention. An alert may include visual, tactile, audible alert, and a combination of these alerts to warn drivers or occupants. These alerts allow receivers, such as drivers or occupants, the ability to react and respond quickly.

As used herein, the term "video analytics" refers to a practical solution for reviewing hours of video (e.g., surveillance video) to identify incidents that are pertinent to what you are looking for. Video analytics is adapted to automatically generate descriptions of what is actually happening in the video (so-called metadata), which can be used to list occupants, seat belt and other objects detected in the video stream (e.g., fastened seat belt, presence of an occupant, postures, gestures, etc.), as well as their appearance and movements.

The term "cyber security" as used herein refers to application of technologies, processes, and controls to protect systems, networks, programs, devices, and data from cyber-attacks.

The term "cyber security module" as used herein refers to a module comprising application of technologies, processes, and controls to protect systems, networks, programs, devices and data from cyber-attacks and threats. It aims to reduce the risk of cyber-attacks and protect against the unauthorized exploitation of systems, networks, and technologies. It includes, but is not limited to, critical infrastructure security, application security, network security, cloud security, Internet of Things (IoT) security.

The term "encrypt" used herein refers to securing digital data using one or more mathematical techniques, along with a password or "key" used to decrypt the information. It refers to converting information or data into a code, especially to prevent unauthorized access. It may also refer to concealing information or data by converting it into a code. It may also be referred to as cipher, code, encipher, encode. A simple example is representing alphabets with numbers - say, 'A' is '01', 'B' is '02', and so on. For example, a message like "HELLO" will be encrypted as "0805121215," and this value will be transmitted over the network to the destination or recipient(s).

The term "decrypt" used herein refers to the process of converting an encrypted message back to its original format. It is generally a reverse process of encryption. It decodes the encrypted information so that only an authorized user can decrypt the data because decryption requires a secret key or password. This term could be used to describe a method of unencrypting the data manually or unencrypting the data using the proper codes or keys.

The term "cyber security threat" used herein refers to any possible malicious attack that seeks to unlawfully access data, disrupt digital operations, or damage information. A malicious act includes but is not limited to damaging data, stealing data, or disrupting digital life in general. Cyber threats include, but are not limited to, malware, spyware, phishing attacks, ransomware, zero-day exploits, trojans, advanced persistent threats, wiper attacks, data manipulation, data destruction, rogue software, malvertising, unpatched software, computer viruses, man-in-the-middle attacks, data breaches, Denial of Service (DoS) attacks, and other attack vectors.

The term "hash value" used herein can be thought of as fingerprints for files. The contents of a file are processed through a cryptographic algorithm, and a unique numerical value, the hash value, is produced that identifies the contents of the file. If the contents are modified in any way, the value of the hash will also change significantly. Example algorithms used to produce hash values: the Message Digest-5 (MD5) algorithm and Secure Hash Algorithm-1 (SHA1).

The term "integrity check" as used herein refers to the checking for accuracy and consistency of system related files, data, etc. It may be performed using checking tools that can detect whether any critical system files have been changed, thus enabling the system administrator to look for unauthorized alteration of the system. For example, data integrity corresponds to the quality of data in the databases and to the level by which users examine data quality, integrity, and reliability. Data integrity checks verify that the data in the database is accurate, and functions as expected within a given application.

The term "alarm" as used herein refers to a trigger when a component in a system or the system fails or does not perform as expected. The system may enter an alarm state when a certain event occurs. An alarm indication signal is a visual signal to indicate the alarm state. For example, when a cyber security threat is detected, a system administrator may be alerted via sound alarm, a message, a glowing LED, a pop-up window, etc. Alarm indication signal may be reported downstream from a detecting device, to prevent adverse situations or cascading effects.

As used herein, the term "network" may include the Internet, a local area network, a wide area network, or combinations thereof. The network may include one or more networks or communication systems, such as the Internet, the telephone system, satellite networks, cable television networks, and various other private and public networks. In addition, the connections may include wired connections (such as wires, cables, fiber optic lines, etc.), wireless connections, or combinations thereof. Furthermore, although not shown, other computers, systems, devices, and networks may also be connected to the network. Network refers to any set of devices or subsystems connected by links joining (directly or indirectly) a set of terminal nodes sharing resources located on or provided by network nodes. The computers use common communication protocols over digital interconnections to communicate with each other. For example, subsystems may comprise the cloud. Cloud refers to servers that are accessed over the Internet, and the software and databases that run on those servers.

The term "autonomous vehicle" also referred to as self-driving vehicle, driverless vehicle, robotic vehicle as used herein refers to a vehicle incorporating vehicular automation, that is, a ground vehicle that can sense its environment and move safely with little or no human input. Self-driving vehicles combine a variety of sensors to perceive their surroundings, such as thermographic cameras, Radio Detection and Ranging (radar), Light Detection and Ranging (lidar), Sound Navigation and Ranging (sonar), Global Positioning System (GPS), odometry and inertial measurement unit. Control systems, designed for the purpose, interpret sensor information to identify appropriate navigation paths, as well as obstacles and relevant signage.

As used herein, the term "semi-autonomous vehicle" refers to vehicles that can operate for extended periods with little human input. A semi-autonomous vehicle cannot drive itself at all times, but does automate some driving functions under ideal conditions like highway driving. A semi-autonomous vehicle may use "autopilot" features. In one embodiment, semi-autonomous vehicles may be able to keep in lane, and they may also be able to park themselves, but they are not self-driving. The semi-autonomous vehicles act independently to some degree.

As used herein the term "connection" as used herein refers to a communication link. It refers to a communication channel that connects two or more devices for the purpose of data transmission. It may refer to a physical transmission medium such as a wire, or to a logical connection over a multiplexed medium such as a radio channel in telecommunications and computer networking. A channel is used for information transfer of, for example a digital bit stream, from one or several senders to one or several receivers. A channel has a certain capacity for transmitting information, often measured by its bandwidth in Hertz (Hz) or its data rate in bits per second. For example, a Vehicle-to-Vehicle (V2V) communication may wirelessly exchange information about the speed, location and heading of surrounding vehicles.

The term "protocol" as used herein refers to a procedure required to initiate and maintain communication; a formal set of conventions governing the format and relative timing of message exchange between two communications terminals; a set of conventions that govern the interaction of processes, devices, and other components within a system; a set of signaling rules used to convey information or commands between boards connected to the bus; a set of signaling rules used to convey information between agents; a set of semantic and syntactic rules that determine the behavior of entities that interact; a set of rules and formats (semantic and syntactic) that determines the communication behavior of simulation applications; a set of conventions or rules that govern the interactions of processes or applications within a computer system or network; a formal set of conventions governing the format and relative timing of message exchange in a computer system; a set of semantic and syntactic rules that determine the behavior of functional units in achieving meaningful communication; a set of semantic and syntactic rules for exchanging information.

As used herein, the term "component" broadly construes hardware, firmware, and/or a combination of hardware, firmware, and software.

The embodiments described herein can be directed to one or more of a system, a method, an apparatus, and/or a computer program product at any possible technical detail level of integration. The computer program product can include a computer readable storage medium (or media) having computer readable program instructions thereon for causing a processor to carry out aspects of the one or more embodiments described herein. The computer readable storage medium can be a tangible device that can retain and store instructions for use by an instruction execution device. For example, the computer readable storage medium can be, but is not limited to, an electronic storage device, a magnetic storage device, an optical storage device, an electromagnetic storage device, a superconducting storage device, and/or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon and/or any suitable combination of the foregoing. A computer readable storage medium, as used herein, does not construe transitory signals per se, such as radio waves and/or other freely propagating electromagnetic waves, electromagnetic waves propagating through a waveguide and/or other transmission media (e.g., light pulses passing through a fiber-optic cable), and/or electrical signals transmitted through a wire.

Computer readable program instructions described herein are downloadable to respective computing/processing devices from a computer readable storage medium and/or to an external computer or external storage device via a network, for example, the Internet, a local area network, a wide area network and/or a wireless network. The network can comprise copper transmission cables, optical transmission fibers, wireless transmission, routers, firewalls, switches, gateway computers, and/or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of the one or more embodiments described herein can be assembler instructions, instruction-set-architecture (ISA) instructions, machine instructions, machine dependent instructions, microcode, firmware instructions, state-setting data, configuration data for integrated circuitry, and/or source code and/or object code written in any combination of one or more programming languages, including an object oriented programming language such as Smalltalk, C++ or the like, and/or procedural programming languages, such as the "C" programming language and/or similar programming languages. The computer readable program instructions can execute entirely on a computer, partly on a computer, as a stand-alone software package, partly on a computer and/or partly on a remote computer or entirely on the remote computer and/or server. In the latter scenario, the remote computer can be connected to a computer through any type of network, including a local area network (LAN) and/or a wide area network (WAN), and/or the connection can be made to an external computer (for example, through the Internet using an Internet Service Provider). In one or more embodiments, electronic circuitry including, for example, programmable logic circuitry, field-programmable gate arrays (FPGA), and/or programmable logic arrays (PLA) can execute the computer readable program instructions by utilizing state information of the computer readable program instructions to personalize the electronic circuitry, in order to perform aspects of the one or more embodiments described herein.

Aspects of the one or more embodiments described herein are described with reference to flowchart illustrations and/or block diagrams of methods, apparatus (systems), and computer program products according to one or more embodiments described herein. Each block of the flowchart illustrations and/or block diagrams, and combinations of blocks in the flowchart illustrations and/or block diagrams, can be implemented by computer readable program instructions. These computer readable program instructions can be provided to a processor of a general purpose computer, special purpose computer and/or other programmable data processing apparatus to produce a machine, such that the instructions, which execute via the processor of the computer or other programmable data processing apparatus, can create means for implementing the functions/acts specified in the flowchart and/or block diagram block or blocks. These computer readable program instructions can also be stored in a computer readable storage medium that can direct a computer, a programmable data processing apparatus and/or other devices to function in a particular manner, such that the computer readable storage medium having instructions stored therein can comprise an article of manufacture including instructions which can implement aspects of the function/act specified in the flowchart and/or block diagram block or blocks. The computer readable program instructions can also be loaded onto a computer, other programmable data processing apparatus and/or other device to cause a series of operational acts to be performed on the computer, other programmable apparatus and/or other device to produce a computer implemented process, such that the instructions which execute on the computer, other programmable apparatus and/or other device implement the functions/acts specified in the flowchart and/or block diagram block or blocks.

The flowcharts and block diagrams in the figures illustrate the architecture, functionality and/or operation of possible implementations of systems, computer-implementable methods and/or computer program products according to one or more embodiments described herein. In this regard, each block in the flowchart or block diagrams can represent a module, segment and/or portion of instructions, which comprises one or more executable instructions for implementing the specified logical function(s). In one or more alternative implementations, the functions noted in the blocks can occur out of the order noted in the Figures. For example, two blocks shown in succession can be executed substantially concurrently, and/or the blocks can sometimes be executed in the reverse order, depending upon the functionality involved. It will also be noted that each block of the block diagrams and/or flowchart illustration, and/or combinations of blocks in the block diagrams and/or flowchart illustration, can be implemented by special purpose hardware-based systems that can perform the specified functions and/or acts and/or carry out one or more combinations of special purpose hardware and/or computer instructions.

While the subject matter described herein is in the general context of computer-executable instructions of a computer program product that runs on a computer and/or computers, those skilled in the art will recognize that the one or more embodiments herein also can be implemented in combination with one or more other program modules. Program modules include routines, programs, components, data structures, and/or the like that perform particular tasks and/or implement particular abstract data types. Moreover, other computer system configurations, including single-processor and/or multiprocessor computer systems, mini-computing devices, mainframe computers, as well as computers, hand-held computing devices (e.g., PDA, phone), microprocessor-based or programmable consumer and/or industrial electronics and/or the like can practice the herein described computer-implemented methods. Distributed computing environments, in which remote processing devices linked through a communications network perform tasks, can also practice the illustrated aspects. However, stand-alone computers can practice one or more, if not all, aspects of the one or more embodiments described herein. In a distributed computing environment, program modules can be located in both local and remote memory storage devices.

As used in this application, the terms "component," "system," "platform," "interface," and/or the like, can refer to and/or can include a computer-related entity or an entity related to an operational machine with one or more specific functionalities. The entities described herein can be either hardware, a combination of hardware and software, software, or software in execution. For example, a component can be, but is not limited to being, a process running on a processor, a processor, an object, an executable, a thread of execution, a program and/or a computer. By way of illustration, both an application running on a server and the server can be a component. One or more components can reside within a process and/or thread of execution and a component can be localized on one computer and/or distributed between two or more computers. In another example, respective components can execute from various computer readable media having various data structures stored thereon. The components can communicate via local and/or remote processes such as in accordance with a signal having one or more data packets (e.g., data from one component interacting with another component in a local system, distributed system and/or across a network such as the Internet with other systems via the signal). As another example, a component can be an apparatus with specific functionality provided by mechanical parts operated by electric or electronic circuitry, which is operated by a software and/or firmware application executed by a processor. In such a case, the processor can be internal and/or external to the apparatus and can execute at least a part of the software and/or firmware application. As yet another example, a component can be an apparatus that provides specific functionality through electronic components without mechanical parts, where the electronic components can include a processor and/or other means to execute software and/or firmware that confers at least in part the functionality of the electronic components. In an aspect, a component can emulate an electronic component via a virtual machine, e.g., within a cloud computing system.

As it is employed in the subject specification, the term "processor" can refer to any computing processing unit and/or device comprising, but not limited to, single-core processors; single-processors with software multi-thread execution capability; multi-core processors; multi-core processors with software multi-thread execution capability; multi-core processors with hardware multi-thread technology; parallel platforms; and/or parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, and/or any combination thereof designed to perform the functions described herein. Further, processors can exploit nano-scale architectures such as, but not limited to, molecular based transistors, switches and/or gates, in order to optimize space usage and/or to enhance performance of related equipment. A combination of computing processing units can implement a processor.

Herein, terms such as "store," "storage," "data store," data storage," "database," and any other information storage component relevant to operation and functionality of a component refer to "memory components," entities embodied in a "memory," or components comprising a memory. Memory and/or memory components described herein can be either volatile memory or nonvolatile memory or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory, and/or nonvolatile random access memory (RAM) (e.g., ferroelectric RAM (FeRAM). Volatile memory can include RAM, which can function as external cache memory, for example. By way of illustration and not limitation, RAM can be available in many forms such as synchronous RAM (SRAM), dynamic RAM (DRAM), synchronous DRAM (SDRAM), double data rate SDRAM (DDR SDRAM), enhanced SDRAM (ESDRAM), Synch link DRAM (SLDRAM), direct Rambus RAM (DRRAM), direct Rambus dynamic RAM (DRDRAM) and/or Rambus dynamic RAM (RDRAM). Additionally, the described memory components of systems and/or computer-implemented methods herein include, without being limited to including, these and/or any other suitable types of memory.

The embodiments described herein include mere examples of systems and computer-implemented methods. It is, of course, not possible to describe every conceivable combination of components and/or computer-implemented methods for purposes of describing the one or more embodiments, but one of ordinary skill in the art can recognize that many further combinations and/or permutations of the one or more embodiments are possible. Furthermore, to the extent that the terms "includes," "has," "possesses," and the like are used in the detailed description, claims, appendices and/or drawings such terms are intended to be inclusive in a manner similar to the term "comprising" as "comprising" is interpreted when employed as a transitional word in a claim.

The descriptions of the one or more embodiments are for purposes of illustration but are not exhaustive or limiting to the embodiments described herein. Many modifications and variations will be apparent to those of ordinary skill in the art without departing from the scope and spirit of the described embodiments. The terminology used herein best explains the principles of the embodiments, the practical application and/or technical improvement over technologies found in the marketplace, and/or to enable others of ordinary skill in the art to understand the embodiments described herein.

Technical problem 1: The current charging systems are not optimum for charging nor have efficient reservation systems. For example, when a driver wants to charge a vehicle, the driver does not know if a charger is available for charging, either for a short time or longer duration. If the charge level has dropped below a threshold, there may not be any chargers available which could leave the driver stranded. Thus, an auto reservation system is needed to ensure that when the charge level drops below a threshold, the system automatically locates available chargers and reserves a charger.

Technical Solution 1: In an aspect, the system detects that charge level for a car has dropped below a threshold. The system a) alerts the driver; b) determines the geographical range based on available charge, weather conditions, total weight, drivers driving habits, etc.; c) scans the area for available charging stations within the range; d) establishes a communication with the closest charge station to identify available charger (the identification algorithm includes determining time or arrival to the available charging station and whether or not the charger is available for duration that is needed to charge the car above a threshold or required level based on final destination or other factors); e) transmit paramètres (e.g., ETA, payment information, vehicle identification, etc.) to reserve the charging station. In an aspect, the system displays the optimal route to arrive for reservation and optimizes the available charge. The driver can activate an autonomous driving to allow the system to drive to the reserved charging station. (More details on operations). In an aspect, the system can initiate a wireless charging or automatically connect to the reserved charging station. In an aspect, the car comprises a charging port or apparatus that can automatically connect to the charging station without the driver's assistance. In another aspect, the car is equipped with a communication module to communicate with a charging station robot that can connect the car to the charging station without requiring a special port.

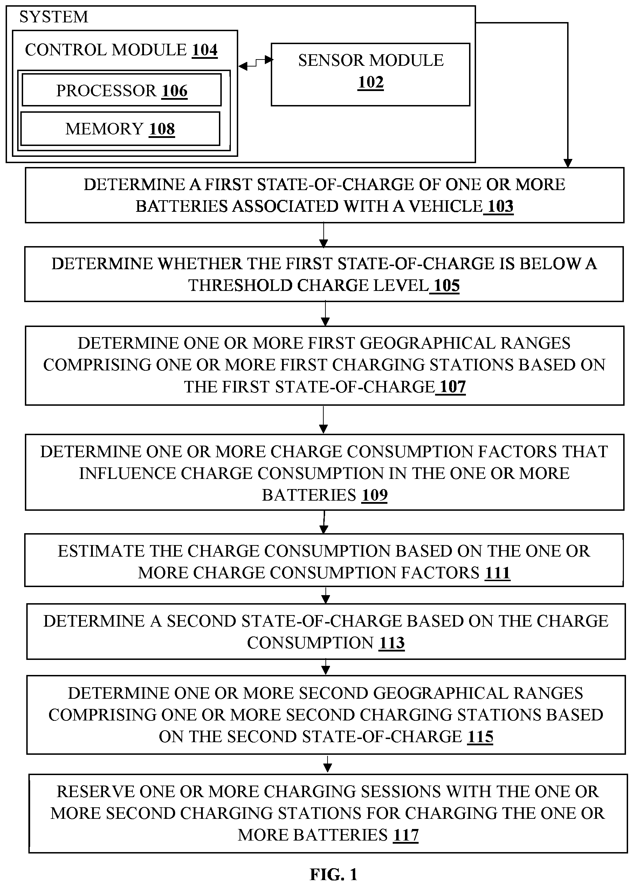

In an aspect, a system is described. **FIG. 1** illustrates a block diagram of a system, according to one or more embodiments. The system comprises: a sensor module 102; and a control module 104. The control module 104 comprises a processor 106; and a memory 108 communicatively coupled to the processor 106. The memory 108 comprising a sensor control module that when executed by the processor 106 causes the processor to: determine a first state-of charge of one or more batteries associated with a vehicle (at step 103); determine whether the first state-of-charge is below a threshold charge level (at step 105); determine one or more first geographical ranges comprising one or more first charging stations based on the first state-of-charge (at step 107); determine one or more charge consumption factors that influence charge consumption in the one or more batteries (at step 109); estimate the enroute charge consumption based on the one or more charge consumption factors (at step 111); determine a second state-of-charge based on the charge consumption (at step 113); determine one or more second geographical ranges comprising one or more second charging stations based on the second state-of-charge (at step 115); and reserve one or more charging sessions with the one or more second charging stations for charging the one or more batteries (at step 117). In one embodiment, the processor 106 is operable to preset the threshold charge level. In one embodiment, the sensor module comprises at least one of one or more weight sensors, one or more load cells, one or more infrared sensors, one or more proximity sensors, one or more ultrasonic sensors, one or more light detection and ranging (LIDAR) sensors, one or more voltage sensors, one or more voltmeters, one or more temperature sensors, one or more light sensors, one or more capacitive load cells, and one or more accelerometers.

The first state-of-charge comprises a measurement of the first amount of electric energy available in the one or more batteries at a specific point in time. The first state-of-charge of the one or more batteries may be expressed as a percentage. The processor determines the first state-of-charge (SoC) of the one or more batteries using one or more voltage sensors by executing the following technical steps. The sensor module may comprise the one or more voltage sensors. The one or more voltage sensors may also be located on a battery management system attached onto or embedded into the battery pack. The battery pack may comprise the one or more batteries. The one or more batteries may be identical or non-identical batteries. The processor is in electric communication with the one or more voltage sensors. The one or more voltage sensors are configured to detect voltages of the battery pack continuously or periodically. The processor receives the detected voltages of the battery pack from the one or more voltage sensors. The processor then determines the average voltage of the battery pack by averaging the detected voltages of the battery pack over a predetermined period of time. The processor then determines a present operational status of the battery pack on the detected voltages of the battery pack. The processor then determines the first state-of-charge of the battery pack (i.e., the one or more batteries) based on the present operating state of the battery pack and the average voltage of the battery pack. In an embodiment, the second state-of-charge (SoC) of the battery pack may also be determined based on the operating state of the battery pack at a later point in a similar way as illustrated above. Other sensors (e.g., hydrometer, voltmeter, etc.) may also be employed in determining the state-of-charges of the batteries.

The processor is then configured to determine whether the first state-of-charge (SoC) of the one or more batteries is less than a threshold charge level. The processor is in electric communication with the one or more voltmeters. The one or more voltmeters is used as SoC indicators. The one or more voltmeters indicates when the first state-of-charge (SoC) of the one or more batteries is below the threshold charge level and communicates this to the processor. The processor determines that the first state-of-charge (SoC) of the one or more batteries is below the threshold charge level based on the communication received from the one or more voltmeters.

The processor then determines the one or more first geographical ranges comprising the one or more first charging stations based on the first state-of-charge. The one or more first geographical ranges comprises the one or more first charging stations. The processor executes the following technical steps for determining the one or more first geographical ranges. The processor determines, using an artificial intelligence engine, a distance range that the vehicle is capable to travel utilizing the first state-of-charge. The processor then identifies, using the artificial intelligence engine, one or more first zones around the vehicle, comprising the one or more first charging stations that are available for charging. The processor then determines, using the artificial intelligence engine, the one or more first geographical ranges encompassing the one or more first zones. The processor then provides, using the artificial intelligence engine, a layout of the one or more first geographical ranges.

In one embodiment, the processor identifies the one or more first zones near the vehicle by executing the following technical steps. The processor determines a real-time location of the vehicle. The processor then determines the one or more first charging stations around the real-time location of the vehicle. The processor then maps the one or more first charging stations around the real-time location of the vehicle into the one or more first zones. The processor then marks the one or more first charging stations within the one or more first zones.

The processor then determines the one or more charge consumption factors that influence the charge consumption in the one or more batteries. In one embodiment, the one or more charge consumption factors comprise one or more external charge consumption factors. In another embodiment, the one or more charge consumption factors comprise one or more internal charge consumption factors. The processor determines the one or more charge consumption factors that influence the charge consumption in the one or more batteries by executing the following technical steps. The processor senses, using the sensor module, continuously one or more external charge consumption factors surrounding the vehicle. The processor then determines at least one of a sudden change and an abnormal rise in the charge consumption of the vehicle. The processor then correlates at least one of a sudden change and an abnormal rise in the charge consumption to the one or more external charge consumption factors. The processor also learns, using an artificial intelligence engine, the one or more external charge consumption factors and the charge consumption based on the correlation.

In one embodiment, the one or more external charge consumption factors comprise at least one of an environmental condition, a road surface condition, a distance between the one or more first charging stations and the vehicle, a traffic condition, a waiting time, and a driving pattern. The environmental condition comprises information of at least one of a weather, a climate, a temperature, a wind, a storm, a tornado, a snow, a sleet, and a rain. The road surface condition comprises information of at least one of a surface slipperiness, a surface friction, a surface inclination, a surface declination, a surface smoothness, and a surface material. The traffic condition comprises information of at least one of an intersection area waiting time, a traffic signal waiting time, a travelling time from a current location of the vehicle to a destination, one or more nearby vehicles, lanes, a predefined travelling speed, and obstructions. The driving pattern comprises information of at least one of a driving profile of a driver, a driving speed, and a driving efficiency score.

In one embodiment, the processor determines the one or more charge consumption factors that influence the charge consumption in the one or more batteries by executing the following technical steps. The processor senses, using the sensor module, continuously one or more internal charge consumption factors. The processor determines at least one sudden change and an abnormal rise in the charge consumption of the vehicle. The processor correlates at least one of a sudden change and an abnormal rise in the charge consumption to the one or more internal charge consumption factors. The processor learns, using an artificial intelligence engine, the one or more internal charge consumption factors and the charge consumption based on the correlation.

In one embodiment, the one or more internal charge consumption factors comprise at least one of a vehicle weight, a state-of-health of one or more batteries, an occupant weight, a luggage weight, a vehicle specification, a vehicle operating mode, and a vehicle fuel operating mode. The vehicle operating mode comprises one of an auto pilot mode, non-autonomous mode, an autonomous mode, and a semi-autonomous mode. The vehicle fuel operating mode comprises one of a hybrid mode, an electric mode, and a combustion fuel mode.

In one embodiment, the processor determines the one or more charge consumption factors that influence the charge consumption in the one or more batteries by executing the following technical steps. The processor senses, using the sensor module, continuously at least one of one or more events, one or more activities, and one or more actions. The processor determines, using an artificial intelligence engine, the one or more charge consumption factors that lead to at least one of the one or more events, the one or more activities, and the one or more actions. The processor then determines the charge consumption for at least one of the one or more events, the one or more activities, and the one or more actions. The processor learns, using an artificial intelligence engine, the one or more charge consumption factors and the charge consumption by correlating them. The processor then estimates the charge consumption for the one or more charge consumption factors that occur in future.

In one embodiment, the one or more events comprises the vehicle travelling in an inclined surface for a predefined distance. For example, the processor determines, using the artificial intelligence engine, a surface inclination as the one or more charge consumption factors that lead to the one or more events. In another embodiment, the one or more events comprise the vehicle travelling with a predefined load. For example, the processor determines, using the artificial intelligence engine, an occupant weight as the one or more charge consumption factors that lead to the one or more events. In another embodiment, the one or more events comprises the vehicle travelling in traffic. For example, the processor determines, using the artificial intelligence engine, a traffic condition as the one or more charge consumption factors that lead to the one or more events. In another embodiment, the one or more events comprises a sudden discharge in the one or more batteries. For example, the processor determines, using the artificial intelligence engine, a state-of-health of one or more batteries as the one or more charge consumption factors that lead to the one or more events.

The processor then determines the second state-of-charge based on the charge consumption. In one embodiment, the second state-of-charge comprises an estimation of a second amount of electric energy in the one or more batteries, considering the one or more charge consumption factors. In an embodiment, the second state-of-charge (SoC) of the battery pack may be determined in a way similar to the determination of the first state-of-charge as illustrated above. Other sensors (e.g., hydrometer, voltmeter, etc.) may also be employed in determining the state-of charges of the batteries.

The processor then determines the one or more second geographical ranges comprising the one or more second charging stations based on the second state-of-charge. In an embodiment, the one or more second geographical ranges covers a portion of the one or more first geographical ranges. The processor determines the one or more second geographical ranges comprising the one or more second charging stations based on the second state-of-charge. The processor determines the one or more second geographical ranges by executing following technical steps. The processor determines, using an artificial intelligence engine, a distance range that the vehicle is capable to travel utilizing the second state-of-charge. The processor identifies, using the artificial intelligence engine, one or more second zones around the vehicle, comprising the one or more second charging stations that are available for charging. The processor determines, using the artificial intelligence engine, the one or more second geographical ranges encompassing the one or more second zones. The processor provides, using the artificial intelligence engine, a layout of the one or more second geographical ranges. In one embodiment, the one or more second geographical ranges is different from the one or more first geographical ranges. In another embodiment, the one or more second geographical ranges completely overlap with the one or more first geographical ranges.

In one embodiment, the processor identifies, using the artificial intelligence engine, one or more second zones, near the vehicle, by executing the following technical steps. The processor determines the real-time location of the vehicle. The processor determines the one or more second charging stations around the real-time location of the vehicle. The processor maps the one or more second charging stations around the real-time location of the vehicle into the one or more second zones. The processor marks the one or more second charging stations within the one or more second zones.

In one embodiment, the processor is operable to establish a communication between the one or more second charging stations and the vehicle. The communication may be a wireless communication. In one embodiment, the communication is a wired communication.

The processor then reserves one or more charging sessions with the one or more second charging stations for charging the one or more batteries. In one embodiment, the processor reserves the one or more second charging stations for charging the one or more batteries by executing the following technical steps. The processor determines a time of arrival of the vehicle at location of the one or more second charging stations. The processor determines a charging duration for the one or more batteries to complete the charging. In an embodiment, the processor determines a charging duration for the one or more batteries to a predefined level. In an embodiment, the processor determines a charging duration for the one or more batteries to a predefined level to complete the trip. The processor determines a time left for the vehicle based on an itinerary associated with a user of the vehicle. The time left may be the time the user is sitting in the coffee shop. The time left may be the time the user is indulged in a work. The processor then computes one or more charging sessions, using an artificial intelligence engine, based on at least one of the time of arrival, the charging duration, and the time left. The processor then compiles one or more messages to the one or more second charging stations based on the one or more charging sessions. The one or more messages comprise information of a vehicle identification number, a location of the vehicle, a distance between the vehicle and charging station, a charging sequence, a charging date, the second state-of-charge, a charging session start time, a charging session end time, a scheduled time period, and a charging duration.

In one embodiment, the processor is operable to enable autonomous mode in the vehicle based on the one or more charging sessions. In another embodiment, the processor communicates instructions to an electric drive unit to autonomously maneuver the vehicle to the one or more second charging stations prior to a scheduled time period.

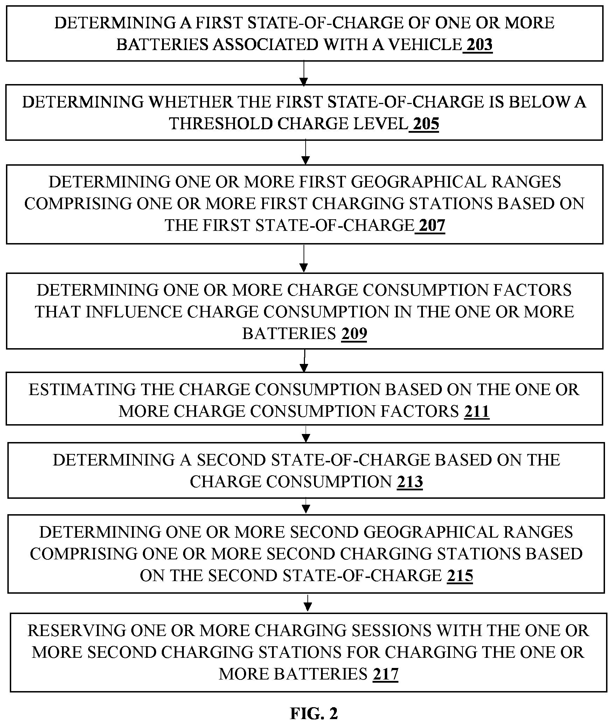

In an aspect, a method of reserving charging sessions is described. FIG. 2 illustrates a method of reserving charging sessions, according to one or more embodiments. The method comprises execution of the following technical steps: determining a first state-of-charge of one or more batteries associated with a vehicle (at step 203); determining whether the first state-of-charge is below a threshold charge level (at step 205); determining one or more first geographical ranges comprising one or more first charging stations based on the first state-of-charge (at step 207); determining one or more charge consumption factors that influences charge consumption in the one or more batteries (at step 209); estimating the charge consumption based on the one or more charge consumption factors (at step 211); determining a second state-of-charge based on the charge consumption (at step 213); determining one or more second geographical ranges comprising one or more second charging stations based on the second state-of-charge (at step 215); and reserving one or more charging sessions with the one or more second charging stations for charging the one or more batteries (at step 217).

In one embodiment, determining the one or more first geographical ranges comprising the one or more first charging stations based on the first state-of-charge comprises: determining, using an artificial intelligence engine, a distance range that the vehicle is capable to travel utilizing the first state-of-charge; identifying, using the artificial intelligence engine, one or more first zones, around the vehicle, comprising the one or more first charging stations that are available for charging; determining, using the artificial intelligence engine, the one or more first geographical ranges encompassing the one or more first zones; and providing, using the artificial intelligence engine, a layout of the one or more first geographical ranges.

In one embodiment, identifying, using the artificial intelligence engine, one or more first zones, near the vehicle, comprising the one or more first charging stations that are available for charging comprises: determining a real-time location of the vehicle; determining the one or more first charging stations around the real-time location of the vehicle; mapping the one or more first charging stations around the real-time location of the vehicle into the one or more first zones; and marking the one or more first charging stations within the one or more first zones.

In one embodiment, determining the one or more charge consumption factors that influences the charge consumption in the one or more batteries comprises: sensing, using a sensor module, continuously one or more external charge consumption factors surrounding the vehicle; determining at least one of a sudden change and an abnormal rise in the charge consumption of the vehicle; correlating at least one of a sudden change and an abnormal rise in the charge consumption to the one or more external charge consumption factors; and learning, using an artificial intelligence engine, the one or more external charge consumption factors and the charge consumption based on the correlation.

In one embodiment, determining the one or more charge consumption factors that influences the charge consumption in the one or more batteries comprises: sensing, using a sensor module, continuously one or more internal charge consumption factors; determining at least one of a sudden change and an abnormal rise in the charge consumption of the vehicle; correlating at least one of a sudden change and an abnormal rise in the charge consumption to the one or more internal charge consumption factors; and learning, using an artificial intelligence engine, the one or more internal charge consumption factors and the charge consumption based on the correlation.

In one embodiment, determining the one or more charge consumption factors that influences the charge consumption in the one or more batteries comprises: sensing, using a sensor module, continuously at least one of one or more events, one or more activities, and one or more actions; determining, using an artificial intelligence engine, the one or more charge consumption factors that lead to at least one of the one or more events, the one or more activities, and the one or more actions; determining the charge consumption for at least one of the one or more events, the one or more activities, and the one or more actions; and learning, using an artificial intelligence engine, the one or more charge consumption factors and the charge consumption.

In one embodiment, determining the one or more second geographical ranges comprising the one or more second charging stations based on the second state-of-charge comprises: determining, using an artificial intelligence engine, a distance range that the vehicle is capable to travel utilizing the second state-of-charge; identifying, using the artificial intelligence engine, one or more second zones, around the vehicle, comprising the one or more second charging stations that are available for charging; determining, using the artificial intelligence engine, the one or more second geographical ranges encompassing the one or more second zones; and providing, using the artificial intelligence engine, a layout of the one or more second geographical ranges.

In one embodiment, identifying, using the artificial intelligence engine, one or more second zones, near the vehicle, comprising the one or more second charging stations that are available for charging comprises: determining a real-time location of the vehicle; determining the one or more second charging stations around the real-time location of the vehicle; mapping the one or more second charging stations around the real-time location of the vehicle into the one or more second zones; and marking the one or more second charging stations within the one or more second zones.

In one embodiment, the method further comprises: establishing a communication between the one or more second charging stations and the vehicle.

In one embodiment, reserving the one or more second charging stations for charging the one or more batteries comprises: determining a time of arrival of the vehicle at a location of the one or more second charging stations; determining a charging duration for the one or more batteries to complete the charging; determining a time left for the vehicle based on an itinerary associated with a user of the vehicle; computing one or more charging sessions, using an artificial intelligence engine, based on at least one of the time of arrival, the charging duration, and the time left; and compiling one or more messages to the one or more second charging stations based on the one or more charging sessions.

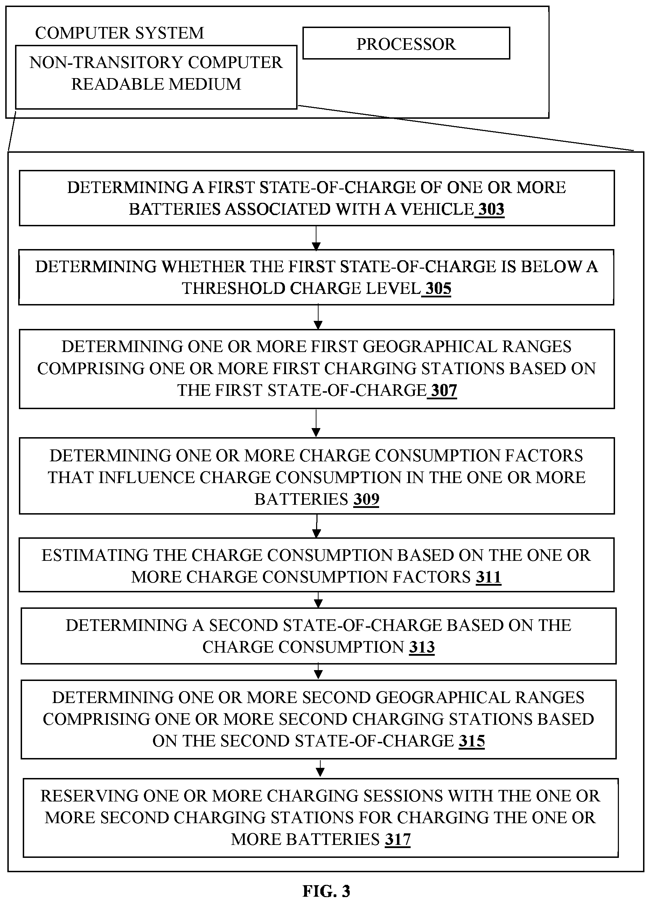

In another aspect, a non-transitory computer readable storage medium is described. FIG. 3 illustrates a non-transitory computer readable storage medium, according to one or more embodiments. The non-transitory computer readable storage medium comprising a sequence of instructions, which when executed by a processor causes: determining a first state-of-charge of one or more batteries associated with a vehicle (at step 303); determining whether the first state-of-charge is below a threshold charge level (at step 305); determining one or more first geographical ranges comprising one or more first charging stations based on the first state-of-charge (at step 307); determining one or more charge consumption factors that influences charge consumption in the one or more batteries (at step 309); estimating the charge consumption based on the one or more charge consumption factors (at step 311); determining a second state-of-charge based on the charge consumption (at step 313); determining one or more second geographical ranges comprising one or more second charging stations based on the second state-of-charge (at step 315); and reserving one or more charging sessions with the one or more second charging stations for charging the one or more batteries (at step 317).

In one embodiment, determining the one or more first geographical ranges comprising the one or more first charging stations based on the first state-of-charge causes: determining, using an artificial intelligence engine, a distance range that the vehicle is capable to travel utilizing the first state-of-charge; identifying, using the artificial intelligence engine, one or more first zones, around the vehicle, comprising the one or more first charging stations that are available for charging; determining, using the artificial intelligence engine, the one or more first geographical ranges encompassing the one or more first zones; and providing, using the artificial intelligence engine, a layout of the one or more first geographical ranges.

In one embodiment, identifying, using the artificial intelligence engine, one or more first zones, near the vehicle, comprising the one or more first charging stations that are available for charging is caused by: determining a real-time location of the vehicle; determining the one or more first charging stations around the real-time location of the vehicle; mapping the one or more first charging stations around the real-time location of the vehicle into the one or more first zones; and marking the one or more first charging stations within the one or more first zones.

In one embodiment, determining the one or more charge consumption factors that influences the charge consumption in the one or more batteries is caused by: sensing, using a sensor module, continuously one or more external charge consumption factors surrounding the vehicle; determining at least one of a sudden change and an abnormal rise in the charge consumption of the vehicle; correlating at least one of a sudden change and an abnormal rise in the charge consumption to the one or more external charge consumption factors; and learning, using an artificial intelligence engine, the one or more external charge consumption factors and the charge consumption based on the correlation.

In one embodiment, determining the one or more charge consumption factors that influences the charge consumption in the one or more batteries causes: sensing, using a sensor module, continuously one or more internal charge consumption factors; determining at least one of a sudden change and an abnormal rise in the charge consumption of the vehicle; correlating at least one of a sudden change and an abnormal rise in the charge consumption to the one or more internal charge consumption factors; and learning, using an artificial intelligence engine, the one or more internal charge consumption factors and the charge consumption based on the correlation.

In one embodiment, determining the one or more charge consumption factors that influences the charge consumption in the one or more batteries causes: sensing, using a sensor module, continuously at least one of one or more events, one or more activities, and one or more actions; determining, using an artificial intelligence engine, the one or more charge consumption factors that lead to at least one of the one or more events, the one or more activities, and the one or more actions; determining the charge consumption for at least one of the one or more events, the one or more activities, and the one or more actions; and learning, using an artificial intelligence engine, the one or more charge consumption factors and the charge consumption.

In one embodiment, determining the one or more second geographical ranges comprising the one or more second charging stations based on the second state-of-charge comprises: determining, using an artificial intelligence engine, a distance range that the vehicle is capable to travel utilizing the second state-of-charge; identifying, using the artificial intelligence engine, one or more second zones, around the vehicle, comprising the one or more second charging stations that are available for charging; determining, using the artificial intelligence engine, the one or more second geographical ranges encompassing the one or more second zones; and providing, using the artificial intelligence engine, a layout of the one or more second geographical ranges.

In one embodiment, identifying, using the artificial intelligence engine, one or more second zones, near the vehicle, comprising the one or more second charging stations that are available for charging causes the processor to: determining a real-time location of the vehicle; determining the one or more second charging stations around the real-time location of the vehicle; mapping the one or more second charging stations around the real-time location of the vehicle into the one or more second zones; and marking the one or more second charging stations within the one or more second zones.

In one embodiment, the non-transitory computer readable storage medium further causes: establishing a communication between the one or more second charging stations and the vehicle.

In one embodiment, reserving the one or more second charging stations for charging the one or more batteries comprises: determining a time of arrival of the vehicle at a location of the one or more second charging stations; determining a charging duration for the one or more batteries to complete the charging; determining a time left for the vehicle based on an itinerary associated with a user of the vehicle; computing one or more charging sessions, using an artificial intelligence engine, based on at least one of the time of arrival, the charging duration, and the time left; and compiling one or more messages to the one or more second charging stations based on the one or more charging sessions.

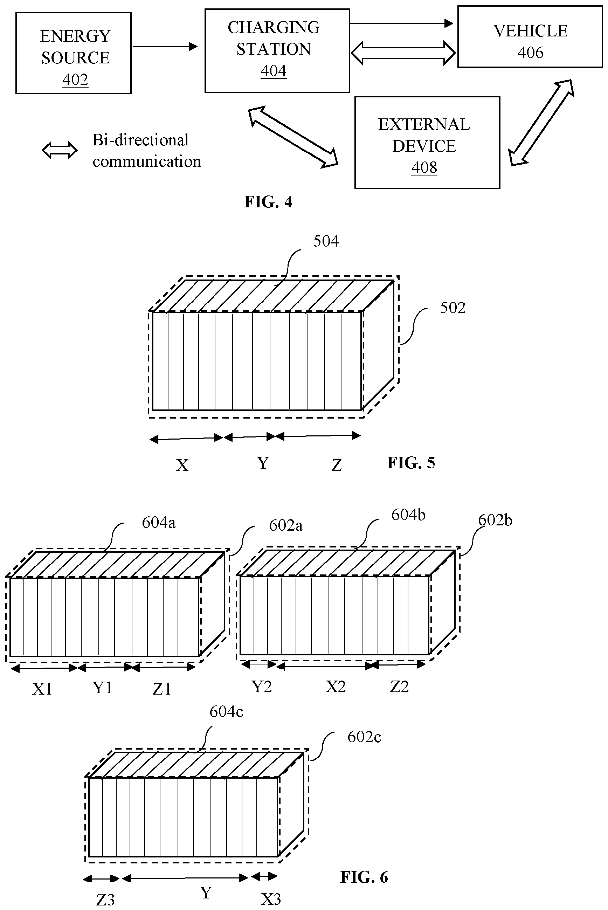

As an example, FIG. 4 illustrates a block diagram for charging a vehicle, according to one or more embodiments. The diagram shown in FIG. 4 comprises an energy source 402, a charging station 404, a vehicle 406 and an external device 408. The energy source 402 supplies power to the charging station 404. The energy source 402 may be a solar power station. The energy source 402 may also be a power storage unit which gets power from an external source. The energy source 402 may be a renewable energy source or a non-renewable energy source. The energy source 402 may also be a power grid. The charging station 404 is configured to charge the vehicle 406. The vehicle 406 may be an electric vehicle. The vehicle 406 may also be one of an autonomous vehicle and a non-autonomous vehicle. Note that the control module is a component within the vehicle 406 configured to locate and reserve charging stations. The communication is used to convey information or instructions, typically by prearrangement between the parties concerned. The signal may also be an electrical impulse or radio wave. In an embodiment, the control module communicates a signal to the charger station to supply electric power to charge the vehicle. The external device 408 may be a smart device associated with a user configured to provide information to the user when the user is away from the vehicle and/or the charging station.

The vehicle 406 described herein may operate in an autonomous mode or a non-autonomous (self-driving) mode. The vehicle 406 comprises a charging system, a battery pack, and a vehicle computer system. In an embodiment, the battery pack comprises an individual battery comprising a plurality of cells. In another embodiment, the battery pack comprises at least one of a first battery (e.g., primary battery), a second battery (e.g., secondary battery), and a third battery (e.g., tertiary battery). The battery pack may comprise identical batteries. The battery pack may comprise non-identical batteries. In an embodiment, each battery of the battery pack may comprise equal capacity to store and deliver power. In another embodiment, each battery of the battery pack comprises different capacity to store and deliver power. Each battery of the battery pack may comprise the plurality of cells. Each battery of the battery pack may be electrically connected with one another to get charged. The charging station 404 charges each battery of the battery pack. In an embodiment, the charging station 404 charges each battery of the battery pack in a random manner (e.g., round robin manner). In another embodiment, the charging station 404 charges each battery of the battery pack in a sequential order (e.g., in a series connection). In yet another embodiment, the charging station 404 charges each battery of the battery pack parallelly at the same time.

The vehicle computer system comprises an infotainment system and/or an automotive head unit. The vehicle computer system comprises an electronic control unit (ECU). The vehicle computer system may also comprise a vehicle gateway system. The vehicle gate way system refers to a device that connects two systems that use different protocols. It is a system which takes care of any outbound or inbound communications between any two vehicle ecosystem units. The vehicle computer system comprises a user interface (e.g., graphical user interface) that enables a user to interact with the system. In an embodiment, icons on a graphical user interface (GUI) or display of the infotainment system of a computer system are re-arranged based on a priority score of the content of the message.

In an embodiment, the vehicle computer system enables the user to interact with the system through a voice input. In another embodiment, the vehicle computer system enables the user to interact with and control the system through a text input. The vehicle computer system, comprising the infotainment system, is a component providing a unified hardware interface for the system, including touch screens, display screens, buttons and system controls for numerous integrated information and entertainment functions. The vehicle computer system is configured to initiate and establish communication with the charging station 404. In an embodiment, the charging station 404 is also configured to initiate and establish communication with the vehicle computer system.

The connection is established between the charging station 404 and the vehicle 406 upon connecting (e.g., via wired connection, wireless connection) the vehicle 406 to the charging station 404. The connection established may provide a bidirectional communication. The charging station 404 and the vehicle 406 can transmit as well as receive signals and/or data in both directions. In another embodiment, communication established between the charging station 404 and the vehicle 406 is through wired communication. In yet another embodiment, communication established between the charging station 404 and the vehicle 406 is through wireless communication technology (e.g., Wireless Fidelity (Wi-Fi^{®}), Bluetooth^{®}, Cellular technology, Zigbee^{®} etc.).

As an example, FIG. 5 illustrates a battery pack 502 comprising an individual battery, according to one or more embodiments. The battery pack 502 herein comprises an individual battery. The battery comprises a plurality of cells 504. The battery pack comprises a first portion X, a second portion Y, and a third portion Z. The first portion X may comprise a first plurality of cells among the plurality of cells of the battery. The second portion Y may comprise a second plurality of cells among the plurality of cells of the battery. The third portion Z may comprise a third plurality of cells among the plurality of cells of the battery.

The first portion X, the second portion Y, and the third portion Z may be categorized based on the state-of-health information at the respective portions. The first portion X may comprise a first state-of health. The second portion Y may comprise a second state-of health. The third portion Z may comprise a third state-of health. In an embodiment, the first portion may refer to a portion of the battery having degraded cells. The second portion may refer to a portion of the battery having healthy cells. The third portion may refer to a portion of the battery having moderate degraded cells. The processor may be configured to detect the state-of-charge of the battery pack having at least one of healthy cells, degraded cells and moderate degraded cells.

As an example, FIG. 6 illustrates a battery pack comprising a plurality of batteries, according to one or more embodiments. The battery pack herein comprises a first battery 602a, a second battery 602b, and a third battery 602c. The first battery 602a may comprise a plurality of first cells 604a. The second battery 602b may comprise a plurality of second cells 604b. The third battery 602c may comprise a plurality of third cells 604c. Each battery of the battery pack is connected electrically to get charged. The charging station charges each battery of the battery pack. The charging station may charge each battery of the battery pack through at least one of randomly, serially, and parallelly.

The charging station may charge at least one of a first portion X, a second portion X, and a third portion Z of the battery pack. The first portion X of the battery pack refers to degraded cells from one or more batteries of the battery pack (X= X1+X2+X3). The second portion Y of the battery pack refers to healthy cells from one or more batteries of the battery pack (Y= Y1+Y2+Y3). The third portion Z of the battery pack refers to moderate degraded cells from one or more batteries of the battery pack (Z= Z1+Z2+Z3). Healthy cells may be contiguous or non-contiguously located within the same battery. Similarly, degraded, and moderate degraded cells may be contiguous or non-contiguously located within the same battery.

The charging station is configured to map the battery pack based on the state-of-health information. In an embodiment, the charging station maps at least one of the degraded cells, the healthy cells, and the moderate degraded cells of the battery pack. The charging station, upon performing mapping the battery pack, computes the state-of-charge considering the state-of-health information.

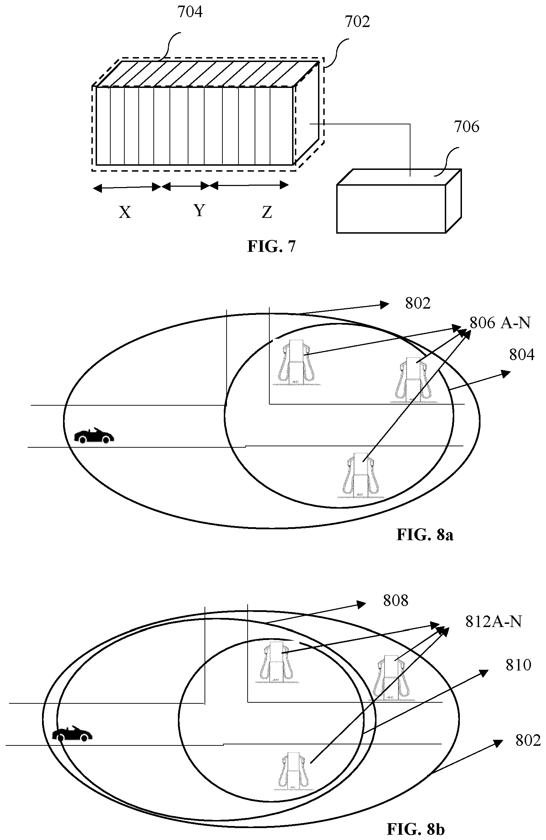

As an example, FIG. 7 schematically shows a battery pack comprising a battery 702 and a battery management system 706, according to one or more embodiments. The battery 702 in turn comprises a plurality of cells 704. The battery management system 706 may include a microprocessor, microcontroller, programmable digital signal processor, or another programmable device. The battery management system 706 may also or alternatively comprise an application specific integrated circuit, a programmable gate array or programmable array logic, a programmable logic device or a digital signal processor. Where the battery management system 706 comprises a programmable device such as the microprocessor, microcontroller or programmable digital signal processor mentioned above, the processor may also comprise computer executable code which controls the operation of the programmable device. In an embodiment, the battery management system 706 resides within an electric vehicle. The battery management system 706 determines the state-of-charge (SoC) of the battery pack and communicates to the charging station via a vehicle computer system.

As an example, FIG. 8a illustrates one or more first geographical ranges 802, according to one or more embodiments. The one or more first geographical ranges 802 comprises the one or more first charging stations 806A-N. The one or more first geographical ranges 802 may comprise the one or more first zones 804 that are contiguous or non-contiguous. The one or more first geographical ranges 802 may be determined based on the first state-of-charge. The processor estimates the distance range that the vehicle can travel using the first state-of-charge. The processor then computes the one or more first geographical ranges 802 based on the distance range estimated.

As an example, FIG. 8b illustrates one or more second geographical ranges 808, according to one or more embodiments. The one or more second geographical ranges 808 comprises the one or more second charging stations 812A-N. The one or more second geographical ranges 808 may comprise the one or more second zones 810 that are contiguous or non-contiguous. The one or more second geographical ranges 808 may be determined based on the second state-of-charge. The second state-of-charge is the state-of-charge of the vehicle after the charge consumption. The processor estimates the distance range that the vehicle can travel using the second state-of-charge. The charge consumption may be due to the one or more charge consumption factors. The processor then computes the one or more second geographical ranges 808 based on the distance range estimated. The one or more second geographical ranges 808 may be different from the one or more first geographical ranges 802. The one or more second geographical ranges 808 may overlap the one or more first geographical ranges 802. The one or more second geographical ranges 808 may cover a portion of the one or more first geographical ranges 802.

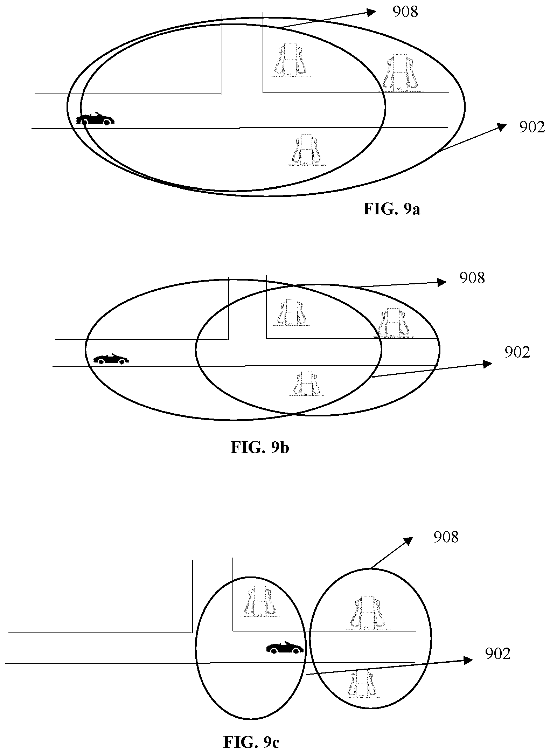

As an example, FIG. 9a shows complete overlapping of a first geographical range 902 and a second geographical range 908, according to one or more embodiments. The first geographical range 902 is determined based on the first state-of-charge, whereas the second geographical range 908 is determined based on the second state-of-charge. As the second state-of-charge is determined based on the charge consumption, the second state-of-charge may be equal or less than the first state-of-charge. Therefore, obviously the second geographical range 908 may have an area equal or less than the area of the first geographical range 902. For example, when the charge consumption is high, the second geographical range 908 may completely overlap the first geographical range 902 (i.e., the entire area of the second geographical range 908 lies within the area of the first geographical range 902).

As an example, FIG. 9b shows the second geographical range 908 covering a portion of the first geographical range 902, according to one or more embodiments. The first geographical range 902 is determined based on the first state-of-charge, whereas the second geographical range 908 is determined based on the second state-of-charge. The first state-of-charge is the state-of-charge of the vehicle at a first specific point of time. The second state-of-charge is the state-of-charge of the vehicle at a second specific point of time (i.e., the charge consumption from the first state-of-charge point to the second state-of-charge point). As the second state-of-charge is determined based on the charge consumption, the second state-of-charge may be equal or less than the first state-of-charge. Therefore, obviously the second geographical range 908 may have an area equal or less than the area of the first geographical range 902. The second geographical range 908 may cover a portion of the first geographical range 902. For example, when the charge consumption, due to the charge consumption factors, is moderate, the second geographical range 908 may fall beyond the first geographical range 902 covering a small portion of the first geographical range 902.

As an example, FIG. 9c shows the second geographical range 908 and the first geographical range 902 that are different from each other, according to one or more embodiments. For example, when the charge consumption, due to the charge consumption factors, is low, the second geographical range 908 may fall completely beyond the first geographical range 902 leaving the first geographical range 902 different from the second geographical range 908.

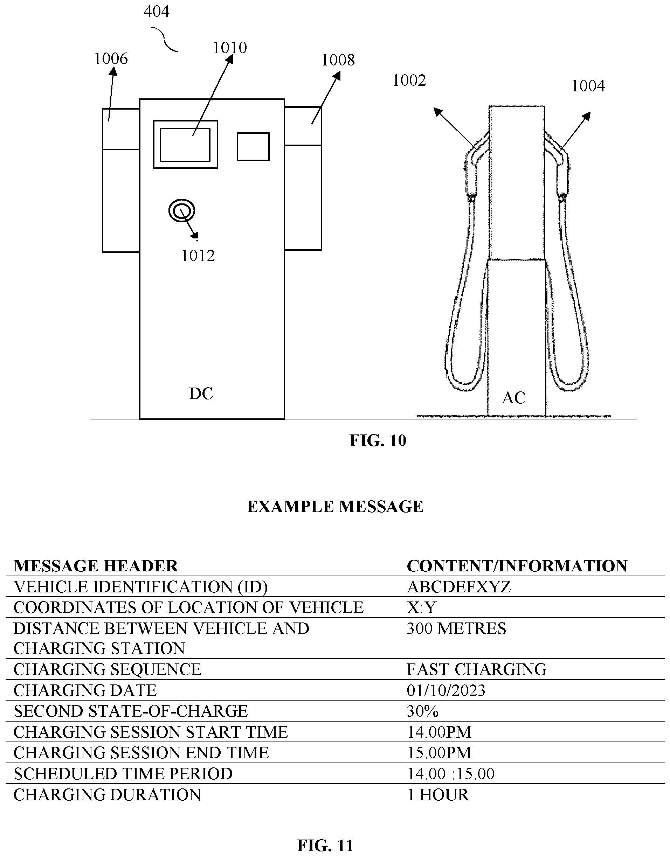

As an example, FIG. 10 shows a schematic diagram of a charging station 404, according to one or more embodiments. In this embodiment, the charging station 404 comprises at least two or more connector interfaces to allow power delivery to Electric vehicles with any one or more matching plug types. The charging station 404 includes a first connector 1002, a second connector 1004, a third connector 1006, and a fourth connector 1008. The connector location depicted by the drawing is for illustration only and does not solidify a design specification, i.e., the plug type and side location may be changed if needed. The charging station 404 has the ability to deliver both DC to DC quick charge and AC to DC. The charging station 404 can charge at least two Electric vehicles simultaneously.

The charging station 404 includes a touch screen device 1010 that allows the consumer/user to receive, send, and interact with web-delivered media and content. The touch screen device 1010 includes a 15 inch (diagonal) or larger touch screen. An interface is interconnected with the charging station 404 using Web portal, Small Business Portal, mobile app services, and the like. The charging station 404 further comprises a button 1012 that allows a consumer/user to select an item displayed on the touch screen device 1010. The button 1012 is an activator that causes selected web content to be sent to a mobile application on the consumer's/user's external device (e.g., phone). The button 1012 may be a physical depressible button or a screen-represented button.

As an example, FIG. 11 illustrates a message communicated to the charging station as described in FIG. 1, according to one or more embodiments. The message comprises information of a vehicle identification number, coordinates of a location of the vehicle, a distance between the vehicle and charging station, a charging sequence, a charging date, the second state-of-charge, a charging session start time, a charging session end time, a scheduled time period, and a charging duration.

The vehicle ID may be a serial identification number, or a tag associated with the electric vehicle configured to identify, recognize, and locate the vehicle. The coordinates of the location of the vehicle indicates the current location of the vehicle. The distance between the vehicle and charging station refers to the distance between the vehicle and charging station in any units (e.g., meters). The charging sequence indicates a charging pattern defined by the charging system or the charging station based on the battery parameters (e.g., state-of-charge, state-of-health) and charging time. The charging date indicates a date on which the charging session is scheduled. The second state-of-charge refers to the state-of-charge of the vehicle after the estimated charge consumption. The charging session start time indicates a time at which the charging session is to be initiated. The charging session end time indicates a time at which the charging session is to be ended/completed. The scheduled time period indicates a range of start time to end time of the charging session. The charging duration refers to total time for which the charging session is scheduled.

Technical problem 2: The current charging systems are not optimum for charging and do not have an efficient reservation system. For example, when a driver wants to charge a vehicle, the driver does not know if a charger is available for charging, either for a short time or longer duration. If the charge level has dropped below a threshold, there may not be any chargers available, which could leave the driver stranded. Thus, an auto reservation system is needed to ensure that when the charge level drops below a threshold, the system automatically locates available chargers and reserves a charger.

Technical Solution 2: In an aspect, once the car has completed the charging above a threshold or for a duration (e.g., 2 hour limit or 1 hour reserved charging time), the car initiates a disconnect request to physically get disconnected from the charging station. If the car is connected with a special port, the system initiates a disconnect procedure (e.g., unlock the connection, gently back up to disconnect, and move away from the parking spot). In an aspect, when a charging station robot is utilized to connect the car to the charging station, the system sends a disconnect message to the robot and unlocks the charging cable. Upon determining that the robot has successfully disconnected the cable and is away from the car, the car can initiate a procedure to free up the parking spot (this can be an invention in itself. For example, a procedure to scan the area to ensure the car can move without getting into contact with other objects, find a new parking spot, notify the driver of the new parking spot, etc.). In another aspect, where the parking lot is monitored by a human or non-human attendant (e.g., a robot), the system can transmit a message to the attendant to allow the attendant to disconnect the charging device from the car. The communication may be over Bluetooth, internet or any comparable wireless communication (e.g., 4G, 5G, V2X).

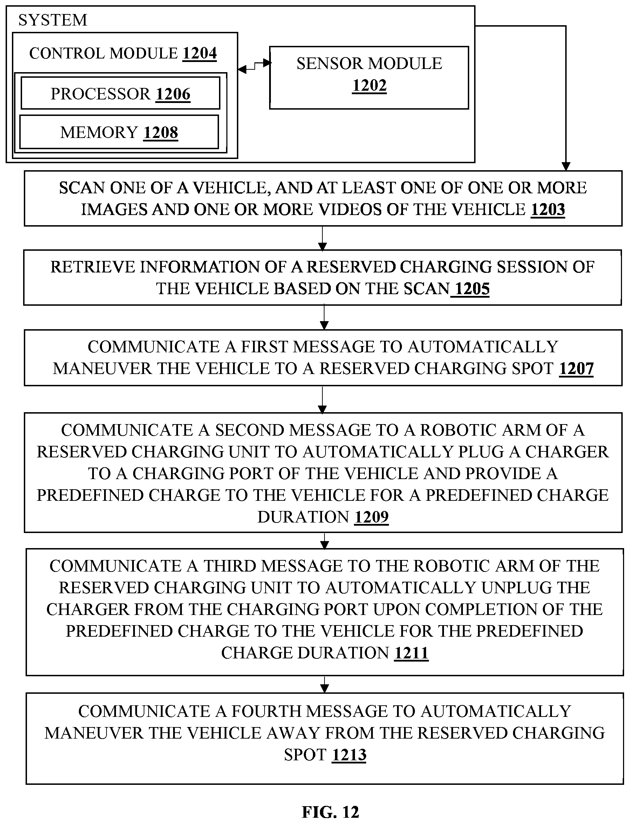

In one aspect, a system is described. FIG. 12 illustrates a system of auto connection and disconnection from a charging station, according to one or more embodiments. The system comprises: a sensor module 1202; and a control module 1204. The control module 1204 comprises: a processor 1206; and a memory 1208 communicatively coupled to the processor 1206. The memory 1208 comprising a sensor control module that, when executed by the processor 1206, causes the processor 1206 to: scan, using a computer vision engine, one of a vehicle, and at least one of one or more images and one or more videos of the vehicle (at step 1203); retrieve information of a reserved charging session of the vehicle based on the scan (at step 1205); communicate a first message to automatically maneuver the vehicle to a reserved charging spot (at step 1207); communicate a second message to a robotic arm of a reserved charging unit to automatically plug a charger to a charging port of the vehicle and provide a predefined charge to the vehicle for a predefined charge duration (at step 1209); communicate a third message to the robotic arm of the reserved charging unit to automatically unplug the charger from the charging port upon completion of the predefined charge to the vehicle for the predefined charge duration (at step 1211); and communicate a fourth message to automatically maneuver the vehicle away from the reserved charging spot (at step 1213).

In one embodiment, the processor 1206 is operable to determine, using an artificial intelligence engine, a specification of the vehicle based on the scan.

In one embodiment, the processor 1206 is operable to recognize, using the computer vision engine, a vehicle identification number based on the scan. The processor 1206 is further operable to retrieve the information of the reserved charging session of the vehicle from a database based on the vehicle identification number.

In one embodiment, the processor 1206 is further operable to recognize, using the computer vision engine, the charging port based on the scan. In one embodiment, the processor 1206 is further operable to communicate a fifth message to the vehicle to automatically open a charging port door upon recognizing the charging port.

In one embodiment, the processor 1206 determining a specification of the vehicle based on the scan is operable to determine at least one of a model, a brand, a configuration, a vehicle type, a battery capacity, a dimension, a charging port type, a charging port location, a charging level, a charging sequence, and a charging duration of the vehicle.

In one embodiment, the processor 1206 recognizes, using the computer vision engine, the vehicle identification number based on the scan is operable to execute the following technical steps. The processor 1206 performs an image analysis, using the computer vision engine, on at least one of the one or more images and the one or more videos of the vehicle. The processor 1206 extracts one or more contents from at least one of the one or more images and the one or more videos of the vehicle. The processor 1206 performs a natural language processing, using an artificial intelligence engine, on the one or more contents to interpret the one or more contents into one or more meaningful information. The processor 1206 recognizes and identifies the vehicle identification number from the one or more meaningful information.

In one embodiment, the processor 1206 is further operable to execute the following technical steps. The processor 1206 matches the vehicle identification number with one or more prestored vehicle identification numbers in the database. The processor 1206 retrieves the information of the reserved charging session of the vehicle from the database based on the matching. In one embodiment, the information of the reserved charging session comprises a charging duration, a charging sequence, a charging port type, a charging port location, a charging session start time, a charging session end time, and a scheduled time period.

In one embodiment, the processor 1206, communicating the first message to automatically maneuver the vehicle to the reserved charging spot, is operable to execute the following technical steps. The processor 1206 extracts a vehicle type from a specification of the vehicle based on the scan. The processor 1206 determines that the vehicle is an autonomous vehicle based on the vehicle type. The processor 1206 communicates the first message to an electric drive unit of the vehicle to automatically maneuver the vehicle to the reserved charging spot. In one embodiment, the electric drive unit is configured to automatically maneuver the vehicle from coordinates of a start location of the vehicle to the reserved charging spot based on the first message.

In another embodiment, the processor 1206, communicating the first message to automatically maneuver the vehicle to the reserved charging spot, is operable to execute the following technical steps. The processor 1206 extracts a vehicle type from a specification of the vehicle based on the scan. The processor 1206 determines that the vehicle is a non- autonomous vehicle based on the vehicle type. The processor 1206 communicates the first message to a first robot to automatically maneuver the vehicle to the reserved charging spot. The robot carries the vehicle and moves to the reserved charging spot. In one embodiment, the first message comprises at least one of a charging duration, a scheduled time period, coordinates of location of the reserved charging spot, coordinates of start location of the vehicle, one or more directions to the reserved charging spot, a charging session start time, and a charging session end time. The first robot is configured to perform the following technical steps. The first robot automatically moves to coordinates of start location of the vehicle. The first robot senses presence of the vehicle by scanning and confirming a vehicle identification number. The first robot automatically aligns to a first predefined position and a first predefined location with respect to the vehicle. The first robot automatically actuates one or more carrying arms of a hydraulic unit to raise and make one or more first predefined contacts with a body of the vehicle for lifting the vehicle. The first robot automatically activates the hydraulic unit of the first robot to lift the vehicle to a first predefined height above a ground surface. The first robot automatically maneuvers the vehicle to the reserved charging spot based on the first message.

In one embodiment, the processor 1206, communicates the second message to the robotic arm of the reserved charging unit to automatically plug the charger to the charging port and provide the predefined charge to the vehicle for the predefined charge duration. The processor communicating the second message to the robotic arm executes the following technical steps. The processor 1206 determines whether the vehicle is in a second predefined position and a second predefined location with respect to the reserved charging unit. The processor 1206 scans, using the sensor module, the vehicle identification number of the vehicle. The processor 1206 performs an image analysis, using a computer vision module, and matches the vehicle identification number with information recorded in a database to ensure that the vehicle identification number has the reserved charging session.

In one embodiment, the processor 1206 is further operable to execute the following technical steps. The processor 1206 recognizes, using the computer vision engine, the charging port based on the image analysis. The processor 1206 extracts coordinates of the charging port. The processor 1206 communicates the second message to the robotic arm of the reserved charging unit to automatically plug the charger into the charging port. The processor 1206 provides the predefined charge to the vehicle for the predefined charge duration.

In one embodiment, the processor 1206 is further operable to determine whether a charging port door is in one of an open state and a closed state. In one embodiment, the processor 1206 is further operable to communicate a fifth message to the vehicle to open the charging port door when the charging port door is in the closed state.

In one embodiment, the processor 1206, communicating the third message to the robotic arm of the reserved charging unit to automatically unplug the charger by executing the following technical steps. The processor 1206 determines whether the vehicle is in a second predefined position and a second predefined location with respect to the reserved charging unit. The processor 1206 recognizes, using the computer vision engine, the charging port by performing an image analysis. The processor 1206 extracts coordinates of the charging port. The processor 1206 communicates the third message to the robotic arm of the reserved charging unit to automatically unplug the charger from the charging port.

In one embodiment, the processor 1206 is further operable to determine whether a charging port door is in one of an open state and a closed state upon unplugging the charger. The processor 1206 is further operable to communicate a fifth message to the vehicle to close the charging port door when the charging port door is in the open state.

In one embodiment, the processor 1206 communicates the fourth message to automatically maneuver the vehicle away from the reserved charging spot. The processor 1206 communicating the fourth message is operable to execute the following technical steps. The processor 1206 extracts a vehicle type from a specification of the vehicle based on the scan. The processor 1206 determines that the vehicle is an autonomous vehicle based on the vehicle type. The processor 1206 communicates the fourth message to an electric drive unit of the vehicle to automatically maneuver the vehicle away from the reserved charging spot.

In one embodiment, the processor 1206 communicates the fourth message to automatically maneuver the vehicle away from the reserved charging spot. The processor 1206 communicating the fourth message is operable to execute the following technical steps. The processor 1206 extracts a vehicle type from a specification of the vehicle based on the scan. The processor 1206 determines that the vehicle is a non-autonomous vehicle based on the vehicle type. The processor 1206 communicates the fourth message to a first robot to automatically maneuver the vehicle away from the reserved charging spot.

In one embodiment, the fourth message comprises at least one of a vehicle identification number, a charging duration, a scheduled time period, coordinates of location of the reserved charging spot, coordinates of start location of the vehicle, coordinates of a parking spot, one or more directions to the parking spot, a charging session start time, and a charging session end time. In one embodiment, the second message comprises at least one of a vehicle identification number, a charging duration, a scheduled time period, coordinates of location of the charging port, a charging port type, a charging sequence, a charging level, a charging port door operating type, a charging session start time, and a charging session end time. In one embodiment, the third message comprises at least one of a vehicle identification number, a charging duration, a scheduled time period, coordinates of location of the charging port, a charging port type, a charging port door operating type, a charging session start time, and a charging session end time.

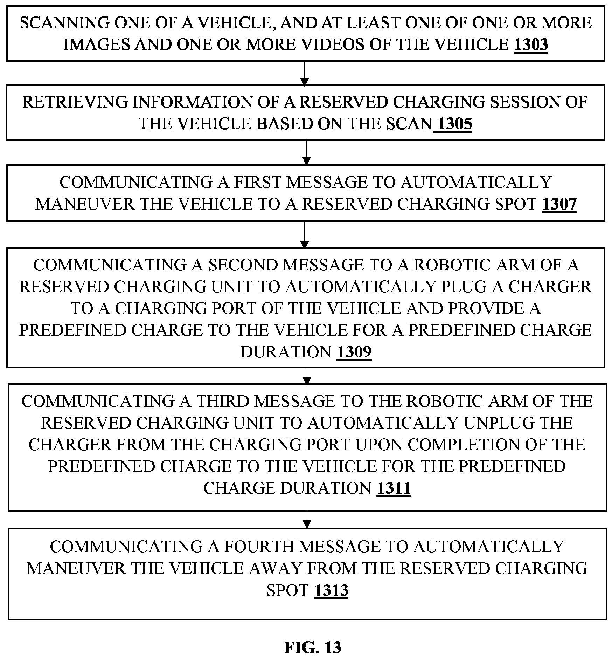

In an aspect, a method is described. FIG. 13 illustrates a method of auto connection and disconnection from a charging station, according to one or more embodiments. The method comprises: scanning, using a computer vision engine, one of a vehicle, and at least one of one or more images and one or more videos of the vehicle (at step 1303); retrieving information of a reserved charging session of the vehicle based on the scan (at step 1305); communicating a first message to automatically maneuver the vehicle to a reserved charging spot (at step 1307); communicating a second message to a robotic arm of a reserved charging unit to automatically plug a charger to a charging port and provide a predefined charge to the vehicle for a predefined charge duration (at step 1309); communicating a third message to the robotic arm of the reserved charging unit to automatically unplug the charger from the charging port upon completion of the predefined charge to the vehicle for the predefined charge duration (at step 1311); and communicating a fourth message to automatically maneuver the vehicle away from the reserved charging spot (at step 1313).

In one embodiment, retrieving the information of the reserved charging session of the vehicle based on the scan further comprises: determining, using an artificial intelligence engine, a specification of the vehicle based on the scan. In another embodiment, retrieving the information of the reserved charging session of the vehicle based on the scan comprises: recognizing, using the computer vision engine, a vehicle identification number based on the scan.

In one embodiment, the method further comprises retrieving the information of the reserved charging session of the vehicle from a database, based on the vehicle identification number. In another embodiment, the method further comprises: recognizing, using the computer vision engine, the charging port based on the scan. In another embodiment, the method further comprises: communicating a fifth message to the vehicle to automatically open a charging port door upon recognizing the charging port.

In one embodiment, the technical step of determining, using the artificial intelligence engine, a specification of the vehicle comprises: determining at least one of a model, a brand, a configuration, a vehicle type, a battery capacity, a dimension, a charging port type, a charging port location, a charging level, a charging sequence, and a charging duration of the vehicle.

In one embodiment, the technical step of recognizing, using the computer vision engine, the vehicle identification number based on the scan comprises the following technical steps: performing an image analysis, using the computer vision engine, on at least one of the one or more images and the one or more videos of the vehicle; extracting one or more contents from at least one of the one or more images and the one or more videos of the vehicle; performing a natural language processing, using an artificial intelligence engine, on the one or more contents to interpret the one or more contents into one or more meaningful information; and recognizing and identifying the vehicle identification number from the one or more meaningful information.

In one embodiment, the method further comprises: matching the vehicle identification number with one or more prestored vehicle identification numbers in the database; and retrieving the information of the reserved charging session of the vehicle from the database based on the matching.

In one embodiment, the technical step of communicating the first message to automatically maneuver the vehicle to the reserved charging spot comprises: extracting a vehicle type from a specification of the vehicle based on the scan; determining that the vehicle is an autonomous vehicle based on the vehicle type; and communicating the first message to an electric drive unit of the vehicle to automatically maneuver the vehicle to the reserved charging spot.

In one embodiment, the technical step of communicating the first message to automatically maneuver the vehicle to the reserved charging spot comprises: extracting a vehicle type from a specification of the vehicle based on the scan; determining that the vehicle is a non-autonomous vehicle based on the vehicle type; and communicating the first message to a first robot to automatically maneuver the vehicle to the reserved charging spot.

In one embodiment, communicating the second message to the robotic arm of the reserved charging unit to automatically plug the charger to the charging port and providing predefined charge to the vehicle for the predefined charge duration comprises: determining whether the vehicle is in a second predefined position and a second predefined location with respect to the reserved charging unit; scanning, using a sensor module, a vehicle identification number of the vehicle; and performing an image analysis, using a computer vision module, to ensure the vehicle identification number is allotted charging for the reserved charging session.

In one embodiment, the method further comprises: recognizing, using the computer vision engine, the charging port based on the image analysis; extracting coordinates of the charging port; communicating the second message to the robotic arm of the reserved charging unit to automatically plug the charger into the charging port; and providing the predefined charge to the vehicle for the predefined charge duration.

In one embodiment, the method further comprises: determining whether a charging port door is in one of an open state and a closed state. In another embodiment, the method further comprises: communicating a fifth message to the vehicle to open the charging port door when the charging port door is in the closed state.

In one embodiment, communicating the third message to the robotic arm of the reserved charging unit to automatically unplug the charger upon completion of the predefined charge to the vehicle for the predefined charge duration comprises: determining whether the vehicle is in a second predefined position and a second predefined location with respect to the reserved charging unit; recognizing, using the computer vision engine, the charging port by performing an image analysis; extracting coordinates of the charging port; and communicating the third message to the robotic arm of the reserved charging unit to automatically unplug the charger from the charging port.

In one embodiment, the method further comprises: determining whether a charging port door is in one of an open state and a closed state upon unplugging the charger. In another embodiment, the method further comprises: communicating a fifth message to the vehicle to close the charging port door when the charging port door is in the open state.

In one embodiment, communicating the fourth message to automatically maneuver the vehicle away from the reserved charging spot comprises the following technical steps: extracting a vehicle type from a specification of the vehicle based on the scan; determining that the vehicle is an autonomous vehicle based on the vehicle type; and communicating the fourth message to an electric drive unit of the vehicle to automatically maneuver the vehicle away from the reserved charging spot.

In one embodiment, communicating the fourth message to automatically maneuver the vehicle away from the reserved charging spot comprises the following technical steps: extracting a vehicle type from a specification of the vehicle based on the scan; determining that the vehicle is a non-autonomous vehicle based on the vehicle type; and communicating the fourth message to a first robot to automatically maneuver the vehicle away from the reserved charging spot.

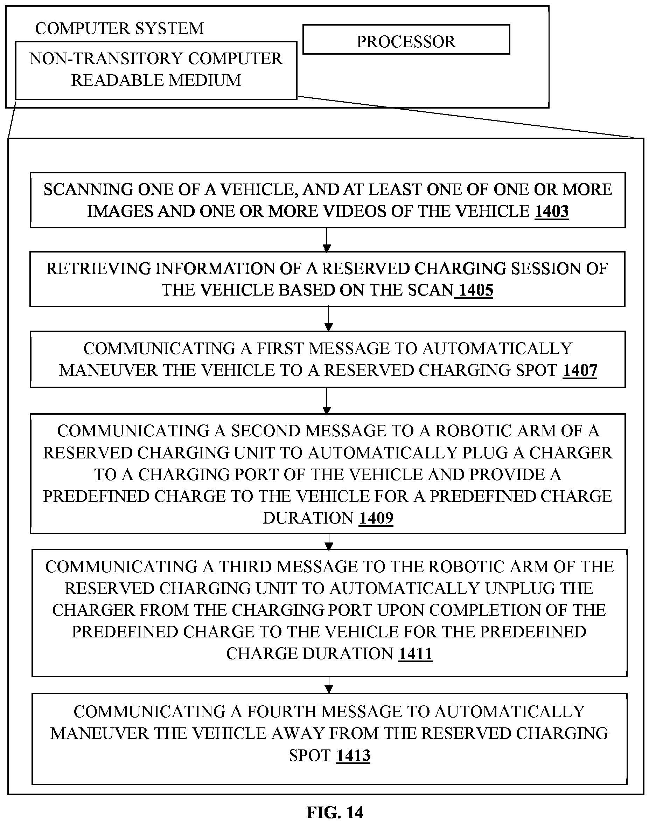

In another aspect, a non-transitory computer readable storage medium is described. FIG. 14 illustrates a non-transitory computer readable storage medium, according to one or more embodiments. The non-transitory computer readable storage medium comprising a sequence of instructions, which when executed by a processor causes: scanning, using a computer vision engine, one of a vehicle, and at least one of one or more images and one or more videos of the vehicle (at step 1403); retrieving information of a reserved charging session of the vehicle based on the scan (at step 1405); communicating a first message to automatically maneuver the vehicle to a reserved charging spot (at step 1407); communicating a second message to a robotic arm of a reserved charging unit to automatically plug a charger to a charging port and provide a predefined charge to the vehicle for a predefined charge duration (at step 1409); communicating a third message to the robotic arm of the reserved charging unit to automatically unplug the charger from the charging port upon completion of the predefined charge to the vehicle for the predefined charge duration (at step 1411); and communicating a fourth message to automatically maneuver the vehicle away from the reserved charging spot (at step 1413).

In one embodiment, communicating the first message to automatically maneuver the vehicle to the reserved charging spot causes: extracting a vehicle type from a specification of the vehicle based on the scan; determining that the vehicle is an autonomous vehicle based on the vehicle type; and communicating the first message to an electric drive unit of the vehicle to automatically maneuver the vehicle to the reserved charging spot.

In one embodiment, communicating the second message to the robotic arm of the reserved charging unit to automatically plug the charger into the charging port and provide the predefined charge to the vehicle for the predefined charge duration further causes: determining whether the vehicle is in a second predefined position and a second predefined location with respect to the reserved charging unit; scanning a vehicle identification number of the vehicle; and performing an image analysis, using a computer vision module, to ensure the vehicle identification number is allotted charging for the reserved charging session.

In one embodiment, the non-transitory computer readable storage medium further causes: recognizing, using the computer vision engine, the charging port based on the image analysis; extracting coordinates of the charging port; communicating the second message to the robotic arm of the reserved charging unit to automatically plug the charger into the charging port; and provide the predefined charge to the vehicle for the predefined charge duration.

In one embodiment, communicating the third message to the robotic arm of the reserved charging unit to automatically unplug the charger upon completion of the predefined charge to the vehicle for the predefined charge duration causes: determining whether the vehicle is in a second predefined position and a second predefined location with respect to the reserved charging unit; recognizing, using the computer vision engine, the charging port by performing an image analysis; extracting coordinates of the charging port; and communicating the third message to the robotic arm of the reserved charging unit to automatically unplug the charger from the charging port.

In one embodiment, communicating the fourth message to automatically maneuver the vehicle away from the reserved charging spot causes: extracting a vehicle type from a specification of the vehicle based on the scan; determining that the vehicle is an autonomous vehicle based on the vehicle type; and communicating the fourth message to an electric drive unit of the vehicle to automatically maneuver the vehicle away from the reserved charging spot.

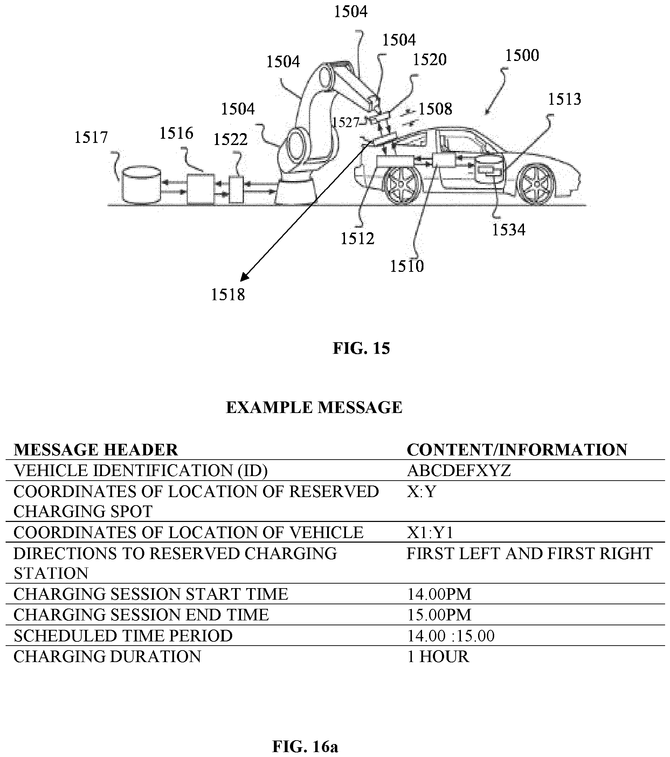

As an example, FIG. 15 illustrates a robotic arm plugging and unplugging a charger from a charging port of the vehicle 1500, according to one or more embodiments. Once the vehicle is maneuvered to the charging spot, the robotic arm of the charging unit maneuvers the charger plug to the charging port. The charging unit comprises a robotic unit which comprises the robotic arm. The charging plug fixes firmly to the charging port to supply electric power in order to charge the battery pack of the vehicle. In an embodiment, the charger plug may be a charging plate and the charging port may be a charging panel. The robotic arm maneuvers the charging plate relative to the charging panel of the vehicle. In one embodiment, the charging unit may comprise one or more robotic arms.

Charging plate 1520 is positioned to a desired or selectable separation distance from the charging panel, as assisted by the separation distance sensor 1527 on the charging plate 1520. The charging plate 1520 may remain at a finite separation distance 1508 from the charging panel 1518, or may directly contact the charging panel (i.e., such that separation distance 1508 is zero). Charging may be by induction. In another embodiment, the separation distance sensor 1527 is alternatively or additionally disposed on a robotic unit arm 1504. Vehicle 1500 receives charging via the charging panel 1518 which in turn charges the energy storage unit 1512. The charging panel controller 1510 is in communication with the energy storage unit 1512, charging panel 1518, vehicle database 1513, charge provider controller 1522, and/or any one of elements of charge provider controller's instrument panel (comprising power management display and charging manual controller). The vehicle database 1513 may comprise the Robotic Unit Charging Data Structure 1534.

The robotic unit is in communication with and/or is interconnected with the charge provider controller 1522, the power source 1516, and the robotic unit database 1517. The power source 1516 supplies power, such as electrical power, to the charging plate 1520 to enable charging of the vehicle via the charging panel 1518. The controller 1524 manoeuvres or operates the robotic unit, either directly and/or completely or with assistance from a remote user, such as a driver or passenger in in vehicle by way of, in one embodiment, the charging manual controller.

Charging panel 1518 of vehicle may be located anywhere on the vehicle, to include, for example, the roof, side panel, trunk, hood, front or rear bumper and wheel hub of the vehicle. In some embodiments, the charging panel 1518 may be deployable, i.e., may extend or deploy only when charging is needed. For example, the charging panel 1518 may typically reside flush with the roof of the vehicle and extend, when required for charging. Similarly, the charging plate 1520 may, in one embodiment, not be connected to the robotic unit and/or robotic unit arm 1504, but instead, for example, may be mounted on the base of the robotic unit. Robotic unit arm 1504 may be configured to maneuvre the charging plate 1520 to any position on the charging panel 1518 of the vehicle so as to enable charging. Control of the charging and/or positioning of the charging plate 1520 may be manual, automatic, or semi-automatic; said control may be performed through a GUI power management display engaged by driver or occupant of the receiving vehicle, and/or a charging operator associated with the power source 1516 and/or the robotic unit.

In some embodiments, the robotic unit is configured to perform additional services beyond battery charging. More specifically, the robotic unit may perform any vehicle maintenance services traditionally performed at vehicle service stations, such as inspection, repair and/or replacement of parts (e.g., electric, or magnetic induction coils, entire battery units or components thereof), upgrading of parts and/or software, and other services known to those skilled in the art.

As an example, FIG. 16a illustrates a first message, according to one or more embodiments. The first message is communicated to a vehicle when the vehicle is an autonomous vehicle. The first message is communicated to an external robot when the vehicle is a non-autonomous vehicle. The first message is adapted to automatically maneuver the vehicle from the current location to the reserved charging spot. The first message comprises at least one of a vehicle ID, a charging duration, a scheduled time period, coordinates of location of the reserved charging spot, coordinates of the start location of the vehicle, one or more directions to the reserved charging spot, a charging session start time, and a charging session end time.

The vehicle ID may be a serial identification number, or a tag associated with the electric vehicle configured to identify, recognize, and locate the vehicle. The coordinates of the location of the vehicle indicates the current location of the vehicle. The coordinates of the location of the reserved charging spot indicates the current location of the reserved charging spot. The scheduled time period indicates a range of start time to end time of the charging session. The charging duration refers to the total time for which the charging session is scheduled. The one or more directions to the reserved charging spot indicates the one or more routes to the reserved charging spot. The charging session start time indicates a time at which the charging session is to be initiated. The charging session end time indicates a time at which the charging session is to be ended/completed.

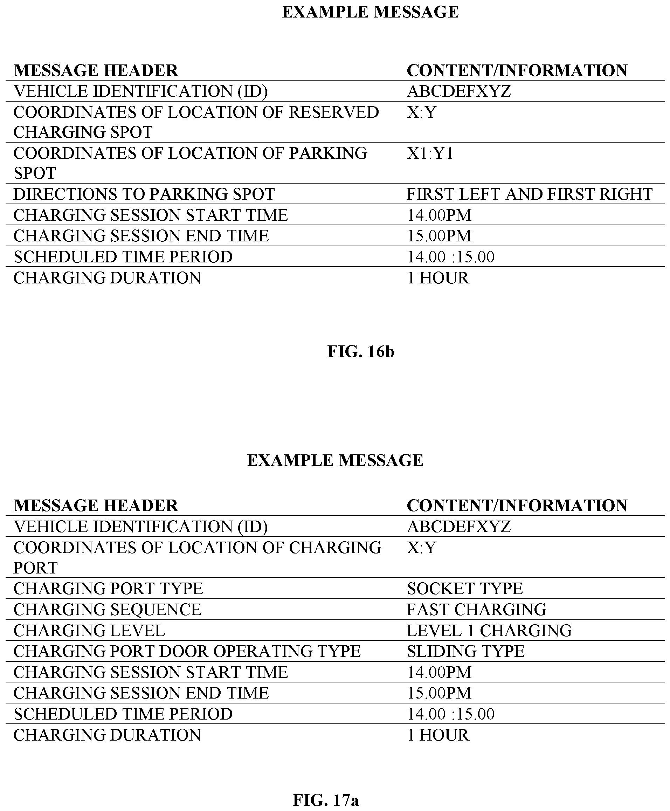

As an example, FIG. 16b illustrates a fourth message, according to one or more embodiments. The fourth message is communicated to a vehicle when the vehicle is an autonomous vehicle. The fourth message is communicated to an external robot when the vehicle is a non-autonomous vehicle. The fourth message is adapted to automatically maneuver the vehicle away from the reserved charging spot. The fourth message comprises at least one of a vehicle ID, charging duration, a scheduled time period, coordinates of the location of the reserved charging spot, coordinates of the location of a parking spot, one or more directions to the parking spot, a charging session start time, and a charging session end time.

The vehicle ID may be a serial identification number, or a tag associated with the electric vehicle configured to identify, recognize, and locate the vehicle. The coordinates of the location of the vehicle indicates the current location of the vehicle. The coordinates of the location of the reserved charging spot indicates the current location of the reserved charging spot. The scheduled time period indicates a range of start time to end time of the charging session. The charging duration refers to total time for which the charging session is scheduled. The one or more directions to the reserved charging spot indicates the one or more routes to the reserved charging spot. The charging session start time indicates a time at which the charging session is to be initiated. The charging session end time indicates a time at which the charging session is to be ended/completed.

As an example, FIG. 17a illustrates a second message, according to one or more embodiments. The second message is communicated to a robotic arm of a reserved charging unit to automatically plug a charger to a charging port of the vehicle. The second message is communicated to the robotic arm whether the vehicle is an autonomous vehicle or a non-autonomous vehicle. The second message comprises at least one of a vehicle identification (ID) number, charging duration, a scheduled time period, coordinates of location of the charging port, a charging port type, a charging sequence, a charging level, operating type of a charging port door, a charging session start time, and a charging session end time.

The vehicle ID number may be a serial identification number, or a tag associated with the electric vehicle configured to identify, recognize, and locate the vehicle. The coordinates of location of the charging port indicates the current position and current location of the charging port. The scheduled time period indicates a range of start time to end time of the charging session. The charging duration refers to total time for which the charging session is scheduled. The charging session start time indicates a time at which the charging session is to be initiated. The charging session end time indicates a time at which the charging session is to be ended/completed. The charging port type refers to one of a charging panel, or a charger socket. The charging sequence indicates one of a regular charging, a fast charging, and a trickle charging. The charging level indicates one of a level 1 charging, a level 2 charging, and a level 3 charging. The operating type of a charging port door indicates one of a sliding type, or a door type.

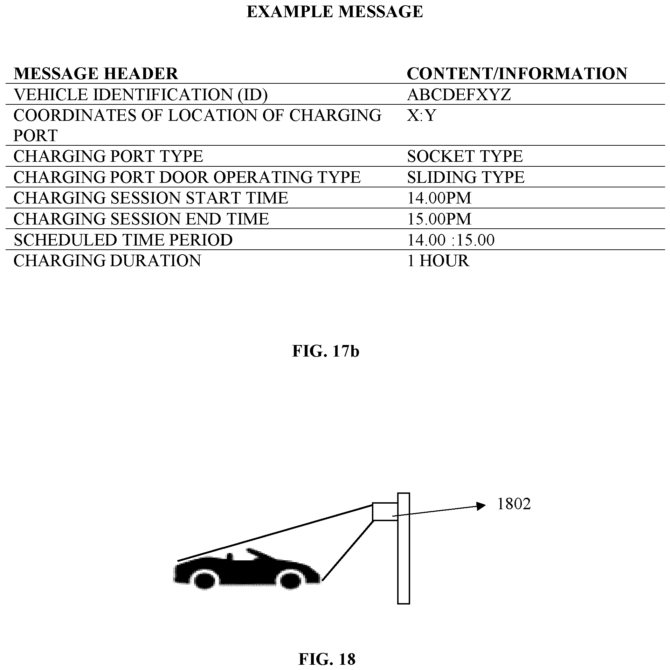

As an example, FIG. 17b illustrates a third message, according to one or more embodiments. The third message is communicated to a robotic arm of a reserved charging unit to automatically unplug a charger away from a charging port of the vehicle. The third message is communicated to the robotic arm whether the vehicle is an autonomous vehicle or a non-autonomous vehicle. The third message comprises at least one of a vehicle identification number, a charging duration, a scheduled time period, coordinates of location of the charging port, a charging port type, operating type of a charging port door, a charging session start time, and a charging session end time.

The vehicle ID number may be a serial identification number, or a tag associated with the electric vehicle configured to identify, recognize, and locate the vehicle. The coordinates of location of the charging port indicates the current position and current location of the charging port. The scheduled time period indicates a range of start time to end time of the charging session. The charging duration refers to total time for which the charging session is scheduled. The charging session start time indicates a time at which the charging session is to be initiated. The charging session end time indicates a time at which the charging session is to be ended/completed. The charging port type refers to one of a charging panel, or a charger socket. The operating type of a charging port door indicates one of a sliding type, or a door type.

FIG. 18 illustrates a scanning of a vehicle, according to one or more embodiments. In an embodiment, the vehicle is approaching the reserved charging station. The sensor module 1802 may be mounted onto an infrastructure. The infrastructure may be located along the route of the vehicle. The infrastructure may be a bridge, an underpass, traffic signal post, a building, etc., along the route of the vehicle. The infrastructure may also be on the charging station. The sensor module 1802 comprises one or more sensors integrated to scan and recognize the vehicle. The one or more sensors comprise one or more cameras, one or more radar sensors, one or more automatic number plate recognition sensors, one or more vision sensors, one or more ultrasonic sensors, etc.

The sensor module 1802 scans the vehicle and recognizes the identity of the vehicle by scanning the vehicle identification number. The processor receives the information scanned and performs further processing for recognizing the identity of the vehicle. The processor receives the information scanned and performs further processing for determining the specification of the vehicle. In an embodiment, the processor determines at least one of a model, a brand, a configuration, a vehicle type, a battery capacity, a dimension, a charging port type, a charging port location, a charging level, a charging sequence, and a charging duration of the vehicle from the specification. The sensor module 1802 may also comprise weight sensors, load cells, etc., to determine the weight of the vehicle.

In an embodiment, the sensor module 1802 captures one or more images or one or more videos of the vehicle. The processor performs an image analysis, using the computer vision engine, on at least one of the one or more images and the one or more videos of the vehicle. The processor then extracts one or more contents from at least one of the one or more images and the one or more videos of the vehicle. The processor then performs a natural language processing, using an artificial intelligence engine, on the one or more contents to interpret the one or more contents into one or more meaningful information. The processor then recognizes and identifies the vehicle identification number from the one or more meaningful information.

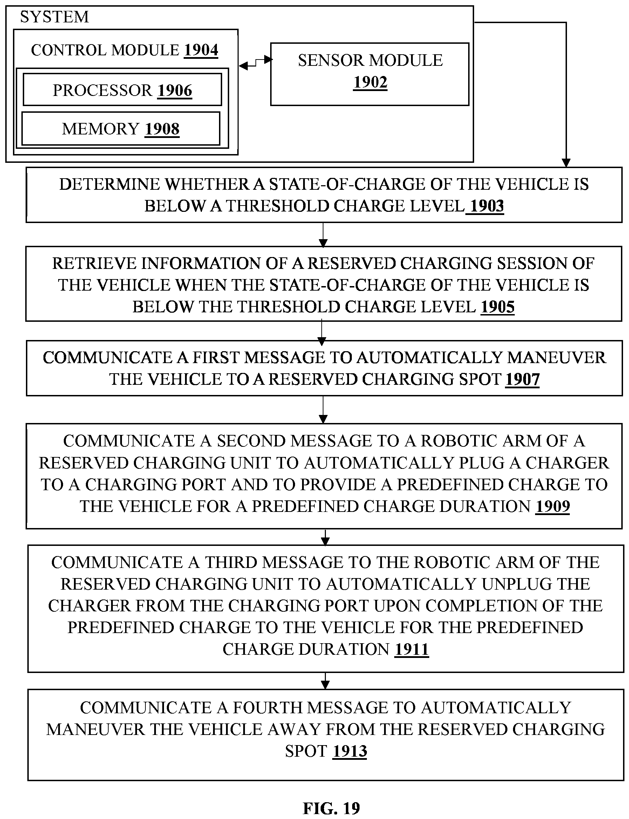

In another aspect, a vehicle is described. FIG. 19 illustrates a vehicle that automatically connects and disconnects from a charging station, according to one or more embodiments. The vehicle comprises a sensor module 1902 and a control module 1904. The control module 1904 comprises a processor 1906 and a memory 1908 communicatively coupled to the processor 1906. The memory 1908 comprising a sensor control module that when executed by the processor 1906 causes the processor 1906 to: determine whether a state-of-charge of the vehicle is below a threshold charge level (at step 1903); retrieve information of a reserved charging session of the vehicle when the state-of-charge of the vehicle is below the threshold charge level (at step 1905); communicate a first message to automatically maneuver the vehicle to a reserved charging spot (at step 1907); communicate a second message to a robotic arm of a reserved charging unit to automatically plug a charger to a charging port and to provide a predefined charge to the vehicle for a predefined charge duration (at step 1909); communicate a third message to the robotic arm of the reserved charging unit to automatically unplug the charger from the charging port upon completion of the predefined charge to the vehicle for the predefined charge duration (at step 1911); and communicate a fourth message to automatically maneuver the vehicle away from the reserved charging spot (at step 1913).

In one embodiment, the processor 1906, communicating the first message to automatically maneuver the vehicle to the reserved charging spot, is operable to: communicate the first message to an electric drive unit of the vehicle to automatically maneuver the vehicle to the reserved charging spot when the vehicle is an autonomous vehicle.

In one embodiment, the processor 1906, communicating the first message to automatically maneuver the vehicle to the reserved charging spot, is operable to: communicate the first message to a first robot to automatically maneuver the vehicle to the reserved charging spot when the vehicle is a non-autonomous vehicle.

In one embodiment, the first message comprises at least one of a charging duration, a scheduled time period, coordinates of location of the reserved charging spot, coordinates of the start location of the vehicle, one or more directions to the reserved charging spot, a charging session start time, and a charging session end time.

In one embodiment, the first robot is configured to automatically move to the coordinates of the start location of the vehicle, sense the presence of the vehicle by scanning and confirming a vehicle identification number, automatically align to a first predefined position and a first predefined location with respect to the vehicle, automatically actuate one or more carrying arms of a hydraulic unit to raise and make one or more first predefined contacts with the body of the vehicle for lifting the vehicle, automatically activate the hydraulic unit of the first robot to lift the vehicle to a first predefined height above a ground surface, and automatically maneuver the vehicle to the reserved charging spot based on the first message.

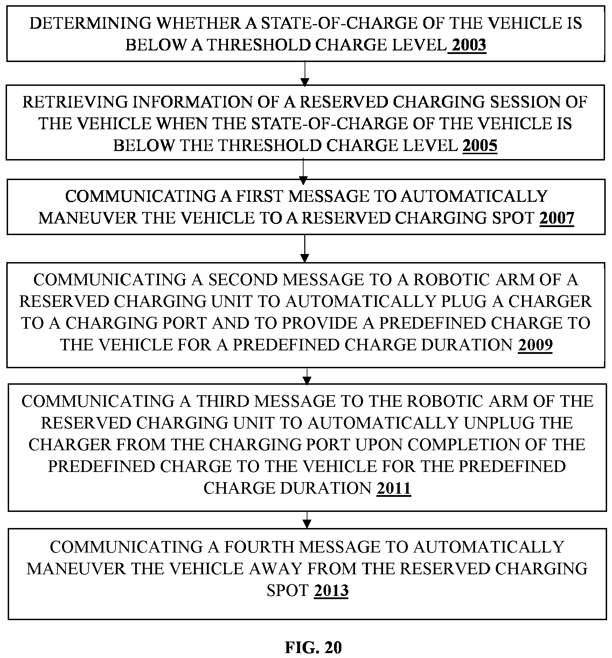

In an aspect, a method is described. FIG. 20 illustrates a method, according to one or more embodiments. The method comprises: determining whether a state-of-charge of a vehicle is below a threshold charge level (at step 2003); retrieving information of a reserved charging session of the vehicle when the state-of-charge of the vehicle is below the threshold charge level (at step 2005); communicating a first message to automatically maneuver the vehicle to a reserved charging spot (at step 2007); communicating a second message to a robotic arm of a reserved charging unit to automatically plug a charger into a charging port and to provide a predefined charge to the vehicle for a predefined charge duration (at step 2009); communicating a third message to the robotic arm of the reserved charging unit to automatically unplug the charger from the charging port upon completion of the predefined charge to the vehicle for the predefined charge duration (at step 2011); and communicating a fourth message to automatically maneuver the vehicle away from the reserved charging spot (at step 2013).

In one embodiment, communicating the first message to automatically maneuver the vehicle to the reserved charging spot comprises: communicating the first message to an electric drive unit of the vehicle to automatically maneuver the vehicle to the reserved charging spot when the vehicle is an autonomous vehicle.

In one embodiment, communicating the first message to automatically maneuver the vehicle to the reserved charging spot comprises: communicating the first message to a first robot to automatically maneuver the vehicle to the reserved charging spot when the vehicle is a non-autonomous vehicle.

In one embodiment, the first message comprises at least one of a charging duration, a scheduled time period, coordinates of location of the reserved charging spot, coordinates of start location of the vehicle, one or more directions to the reserved charging spot, a charging session start time, and a charging session end time.

In one embodiment, the first robot is configured to automatically move to coordinates of start location of the vehicle; sense presence of the vehicle by scanning and confirming a vehicle identification number; automatically align to a first predefined position and a first predefined location with respect to the vehicle; automatically actuate one or more carrying arms of a hydraulic unit to raise and make one or more first predefined contacts with a body of the vehicle for lifting the vehicle; automatically activate the hydraulic unit of the first robot to lift the vehicle to a first predefined height above a ground surface; and automatically maneuver the vehicle to the reserved charging spot based on the first message.

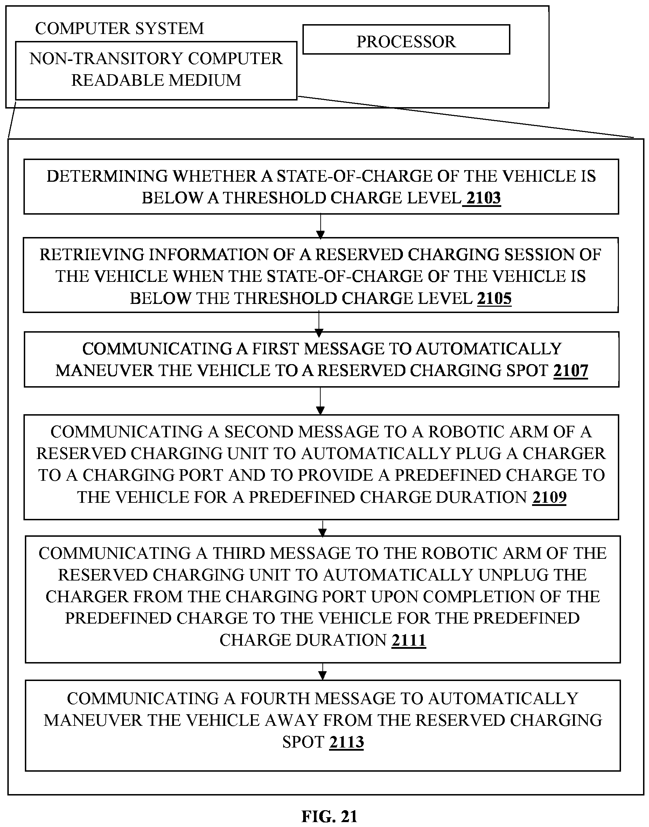

In an aspect, a non-transitory computer readable storage medium is described. FIG. 21 illustrates a non-transitory computer readable storage medium, according to one or more embodiments. The non-transitory computer readable storage medium comprises a sequence of instructions, which when executed by a processor causes: determining whether a state-of-charge of a vehicle is below a threshold charge level (at step 2103); retrieving information of a reserved charging session of the vehicle when the state-of-charge of the vehicle is below the threshold charge level (at step 2105); communicating a first message to automatically maneuver the vehicle to a reserved charging spot (at step 2107); communicating a second message to a robotic arm of a reserved charging unit to automatically plug a charger into a charging port and to provide a predefined charge to the vehicle for a predefined charge duration (at step 2109); communicating a third message to the robotic arm of the reserved charging unit to automatically unplug the charger from the charging port upon completion of the predefined charge to the vehicle for the predefined charge duration (at step 2111); and communicating a fourth message to automatically maneuver the vehicle away from the reserved charging spot (at step 2113).

In one embodiment, communicating the first message to automatically maneuver the vehicle to the reserved charging spot causes: communicating the first message to an electric drive unit of the vehicle to automatically maneuver the vehicle to the reserved charging spot when the vehicle is an autonomous vehicle.

In one embodiment, communicating the first message to automatically maneuver the vehicle to the reserved charging spot causes: communicating the first message to a first robot to automatically maneuver the vehicle to the reserved charging spot when the vehicle is a non-autonomous vehicle.

In one embodiment, the first message comprises at least one of a charging duration, a scheduled time period, coordinates of location of the reserved charging spot, coordinates of start location of the vehicle, one or more directions to the reserved charging spot, a charging session start time, and a charging session end time.

Technical Problem 3: The problem is that when a car needs to be charged and there are no available charging stations at the current location. This can be based on various reasons, including the driver did not reserve a spot, someone took their spot without reservation, or the reserved charging station is not fully operational. Regardless, the driver would like to find a charging station. Thus, a charging station locator needs to be included.

Technical Solution 3: In an aspect, every EV is provided with a charging stations locator (CSL). The CSL continuously monitors the locations of all available charging stations . As the vehicle approaches the charging stations, the CSL pings the reserved charging station to determine its operational status and occupancy status. If the operational status is clear and a charging station spot is not occupied, the charging station is highlighted, and direction provided. In an aspect, the charging station direction is zoomed in on the charging station spot. However, if there is no available charging station at the desired or nearest set of CS, the CSL identifies the next closest CS toward desired destination. The identified CS may be based on available charge.

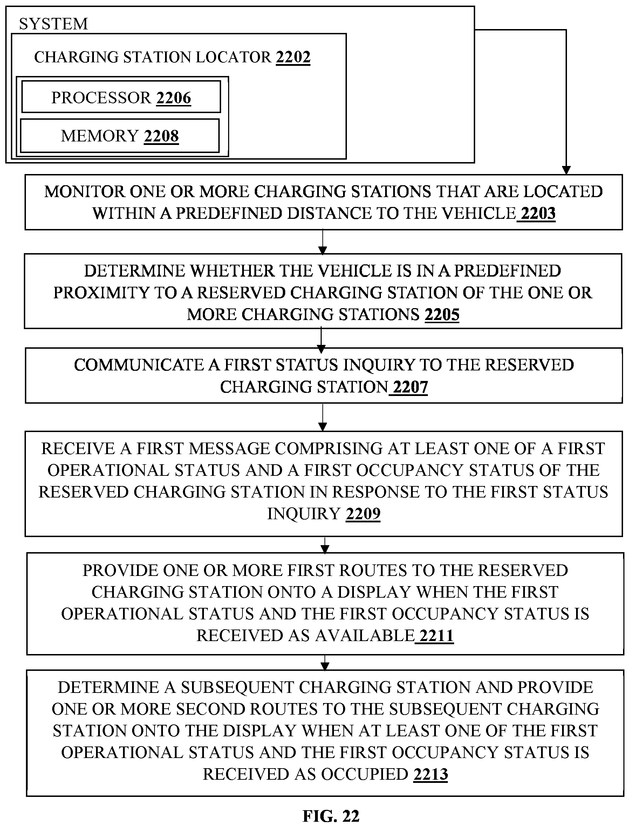

In an aspect, a system is described. FIG. 22 illustrates a system that automatically locates available chargers, according to one or more embodiments. The system comprises a charging station locator 2202. The charging station locator 2202 comprises a memory 2208, and a processor 2206 that is communicatively coupled to the memory 2208. The processor 2206 is operable to: monitor one or more charging stations that are located within a predefined distance to the vehicle (at step 2203); determine whether the vehicle is in a predefined proximity to a reserved charging station of the one or more charging stations (at step 2205); communicate a first status inquiry to the reserved charging station (at step 2207); receive a first message comprising at least one of a first operational status and a first occupancy status of the reserved charging station in response to the first status inquiry (at step 2209); provide one or more first routes to the reserved charging station onto a display when the first operational status and the first occupancy status is received as available (at step 2211); and determine a subsequent charging station and provide one or more second routes to the subsequent charging station onto the display when at least one of the first operational status and the first occupancy status is received as occupied (at step 2213).

In one embodiment, the processor 2206 is operable to: determine the subsequent charging station based on a state-of-charge of one or more batteries associated with the vehicle. In another embodiment, the processor 2206 is operable to: determine the subsequent charging station based on a route that the vehicle is travelling. In another embodiment, the processor 2206 is operable to: determine the subsequent charging station based on an itinerary of a user travelling in the vehicle. In another embodiment, the processor 2206 is operable to: determine the subsequent charging station based on a second operational status and a second occupancy status of the subsequent charging station. The subsequent charging station is the next closest charging station.

In one embodiment, the processor 2206, monitoring the one or more charging stations that are located within the predefined distance to the vehicle, is operable to execute the following technical steps. The processor 2206 determines a real-time location of the vehicle using one or more sensors associated with the vehicle. The processor 2206 determines, using an artificial intelligence engine, one or more zones comprising the one or more charging stations around the real-time location of the vehicle for the predefined distance. The processor 2206 identifies the one or more charging stations that are located within the one or more zones within the predefined distance to the vehicle. The processor 2206 monitors locations of the one or more charging stations that are identified within the predefined distance to the vehicle.

In one embodiment, the processor 2206, monitoring the one or more charging stations that are located within the predefined distance to the vehicle, is operable to execute the following technical steps. The processor 2206 determines a real-time location of the vehicle using one or more sensors associated with one or more external infrastructures along a route of the vehicle. The processor 2206 determines, using an artificial intelligence engine, one or more zones comprising the one or more charging stations around the real-time location of the vehicle of the predefined distance. The processor 2206 identifies the one or more charging stations that are located within the one or more zones within the predefined distance to the vehicle. The processor 2206 monitors locations of the one or more charging stations that are identified with the predefined distance to the vehicle.

In one embodiment, the processor 2206, determining whether the vehicle is in the predefined proximity to the reserved charging station of the one or more charging stations, is operable to execute the following technical steps. The processor 2206 determines a real-time location of the vehicle using one or more sensors associated with one of the vehicle, and one or more external infrastructures along a route of the vehicle. The processor 2206 determines a real-time location of the reserved charging station. The processor 2206 matches the real-time location of the vehicle and the real-time location of the reserved charging station. The processor 2206 determines whether the vehicle is within the predefined proximity to the reserved charging station based on an offset between the real-time location of the vehicle and the real-time location of the reserved charging station.

In one embodiment, the first operational status of the reserved charging station is received as available when the reserved charging station has completed its operation of charging to a previous vehicle and is available for charging the vehicle. In another embodiment, the first occupancy status of the reserved charging station is received as available when the reserved charging station has completed its operation of charging to a previous vehicle and the previous vehicle has moved away from the reserved charging station, leaving the reserved charging station available for charging the vehicle.

In another embodiment, the first operational status of the reserved charging station is received as occupied when the reserved charging station is in the process of charging a previous vehicle and is unavailable.

In one embodiment, the first occupancy status of the reserved charging station is received as occupied when the reserved charging station is in a process of charging a previous vehicle and the previous vehicle is blocking the reserved charging station leaving the reserved charging station unavailable.

In one embodiment, the display is associated with one of an infotainment unit of the vehicle, and an external device of a user.

In one embodiment, the processor 2206, providing the one or more first routes to the reserved charging station onto the display when the first operational status and the first occupancy status is received as available, is operable to execute the following technical steps. The processor 2206 determines that the reserved charging station is available for charging the vehicle when the first operational status and the first occupancy status is received as available. The processor 2206 determines a real-time location of the vehicle using one or more sensors associated with one of the vehicle, and one or more external infrastructures along a route of the vehicle. The processor 2206 retrieves a real-time location of the reserved charging station from a database. The processor 2206 identifies the one or more first routes that lead to the real-time location of the reserved charging station from the real-time location of the vehicle. The processor 2206 provides the one or more first routes to the reserved charging station onto the display.

In one embodiment, the processor 2206 is operable to determine that the reserved charging station is unavailable for charging the vehicle when at least one of the first operational status and the first occupancy status is received as occupied.

In one embodiment, the processor 2206 is further operable to execute the following technical steps. The processor 2206 determines a real-time location of the vehicle using one or more sensors associated with one of the vehicle, and one or more external infrastructures along a route of the vehicle. The processor 2206 identifies the subsequent charging station of the one or more charging stations within the predefined distance of the vehicle. The processor 2206 communicates a second status inquiry to the subsequent charging station. The processor 2206 receives a second message comprising at least one of a second operational status and a second occupancy status of the subsequent charging station in response to the second status inquiry. The processor 2206 determines that the subsequent charging station is available for charging the vehicle when the second operational status and the second occupancy status is received as available.

In one embodiment, the processor 2206 is further operable to execute the following technical steps. The processor 2206 retrieves a real-time location of the subsequent charging station from a database. The processor 2206 identifies the one or more second routes that lead to the real-time location of the subsequent charging station from the real-time location of the vehicle. The processor 2206 provides the one or more second routes to the subsequent charging station onto the display.

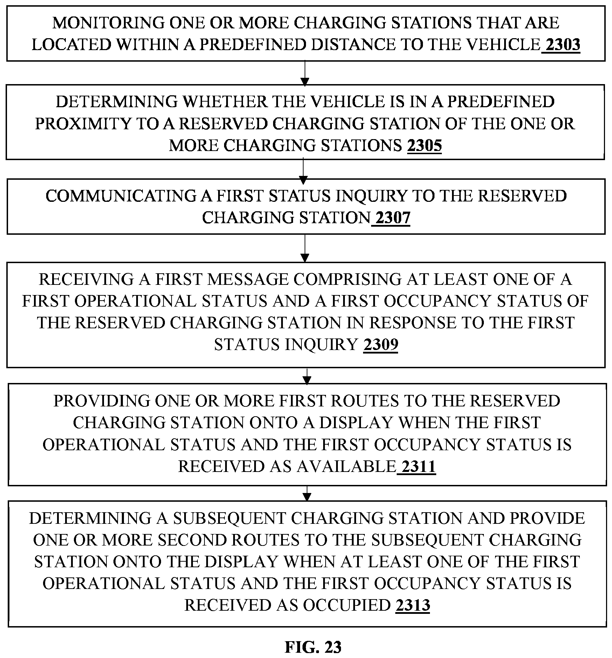

In an aspect, a method is described. FIG. 23 illustrates a method, according to one or more embodiments. The method comprises: monitoring one or more charging stations that are located within a predefined distance to a vehicle (at step 2303); determining whether the vehicle is in a predefined proximity to a reserved charging station of the one or more charging stations (at step 2305); communicating a first status inquiry to the reserved charging station (at step 2307); receiving a first message comprising at least one of a first operational status and a first occupancy status of the reserved charging station in response to the first status inquiry (at step 2309); providing one or more first routes to the reserved charging station onto a display when the first operational status and the first occupancy status is received as available (at step 2311); and determining a subsequent charging station and providing one or more second routes to the subsequent charging station onto the display when at least one of the first operational status and the first occupancy status is received as occupied (at step 2313).

In one embodiment, monitoring the one or more charging stations that are located within the predefined distance to the vehicle further comprises: determining a real-time location of the vehicle using one or more sensors associated with the vehicle; determining, using an artificial intelligence engine, one or more zones comprising the one or more charging stations around the real-time location of the vehicle for the predefined distance; identifying the one or more charging stations that are located within the one or more zones within the predefined distance to the vehicle; and monitoring locations of the one or more charging stations that are identified within the predefined distance to the vehicle.

In one embodiment, monitoring the one or more charging stations that are located within the predefined distance to the vehicle further comprises: determining a real-time location of the vehicle using one or more sensors associated with one or more external infrastructures along a route of the vehicle; determining, using an artificial intelligence engine, one or more zones comprising the one or more charging stations around the real-time location of the vehicle for the predefined distance; identifying the one or more charging stations that are located within the one or more zones within the predefined distance to the vehicle; and monitoring locations of the one or more charging stations that are identified within the predefined distance to the vehicle.

In one embodiment, determining whether the vehicle is in the predefined proximity to the reserved charging station of the one or more charging stations further comprises: determine a real-time location of the vehicle using one or more sensors associated with one of the vehicle, and one or more external infrastructures along a route of the vehicle; determine a real-time location of the reserved charging station; match the real-time location of the vehicle and the real-time location of the reserved charging station; and determine whether the vehicle is in the predefined proximity to the reserved charging station based on an offset between the real-time location of the vehicle and the real-time location of the reserved charging station.

In one embodiment, providing the one or more first routes to the reserved charging station onto the display when the first operational status and the first occupancy status is received as available further comprises: determining that the reserved charging station is available for charging the vehicle when the first operational status and the first occupancy status is received as available; determining a real-time location of the vehicle using one or more sensors associated with one of the vehicle, and one or more external infrastructures along a route of the vehicle; retrieving a real-time location of the reserved charging station from a database; identifying the one or more first routes that lead to the real-time location of the reserved charging station from the real-time location of the vehicle; and providing the one or more first routes to the reserved charging station onto the display.

In one embodiment, determining the subsequent charging station and providing the one or more second routes to the subsequent charging station onto the display when at least one of the first operational status and the first occupancy status is received as occupied further comprises: determining that the reserved charging station is unavailable for charging the vehicle when at least one of the first operational status and the first occupancy status is received as occupied.

In one embodiment, determining the subsequent charging station and providing the one or more second routes to the subsequent charging station onto the display when at least one of the first operational status and the first occupancy status is received as occupied further comprises: determining a real-time location of the vehicle using one or more sensors associated with one of the vehicle, and one or more external infrastructures along a route of the vehicle; identifying the subsequent charging station of the one or more charging stations within the predefined distance of the vehicle; communicating a second status inquiry to the subsequent charging station; receiving a second message comprising at least one of a second operational status and a second occupancy status of the subsequent charging station in response to the second status inquiry; and determining that the subsequent charging station is available for charging the vehicle when the second operational status and the second occupancy status is received as available.

In one embodiment, determining the subsequent charging station and providing the one or more second routes to the subsequent charging station onto the display when at least one of the first operational status and the first occupancy status is received as occupied further comprises: retrieving a real-time location of the subsequent charging station from a database; identifying the one or more second routes that lead to the real-time location of the subsequent charging station from the real-time location of the vehicle; and providing the one or more second routes to the subsequent charging station onto the display.

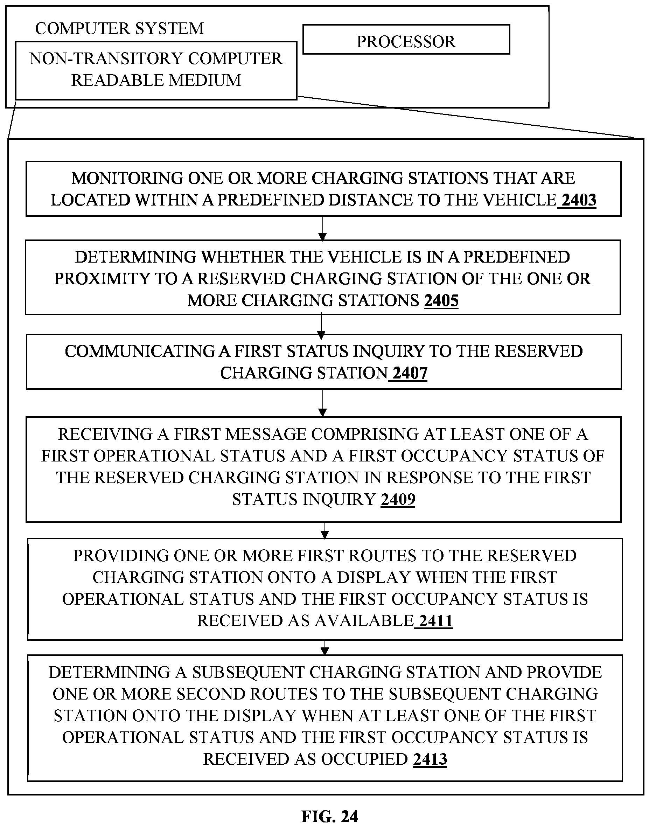

In an aspect, a non-transitory computer readable storage medium is described. FIG. 24 illustrates a non-transitory computer readable storage medium, according to one or more embodiments. The non-transitory computer readable storage medium comprising a sequence of instructions, which when executed by a processor causes: monitoring one or more charging stations that are located within a predefined distance to a vehicle (at step 2403); determining whether the vehicle is in a predefined proximity to a reserved charging station of the one or more charging stations (at step 2405); communicating a first status inquiry to the reserved charging station (at step 2407); receiving a first message comprising at least one of a first operational status and a first occupancy status of the reserved charging station in response to the first status inquiry (at step 2409); providing one or more first routes to the reserved charging station onto a display when the first operational status and the first occupancy status is received as available (at step 2411); and determining a subsequent charging station and providing one or more second routes to the subsequent charging station onto the display when at least one of the first operational status and the first occupancy status is received as occupied (at step 2413).

In one embodiment, determining the subsequent charging station and providing the one or more second routes to the subsequent charging station onto the display further causes: determining that the reserved charging station is unavailable for charging the vehicle when at least one of the first operational status and the first occupancy status is received as occupied.

In one embodiment, determining the subsequent charging station and providing the one or more second routes to the subsequent charging station onto the display further causes the following technical steps to be executed. The non-transitory computer readable storage medium determines a real-time location of the vehicle using one or more sensors associated with one of the vehicle, and one or more external infrastructures along a route of the vehicle. The non-transitory computer readable storage medium causes identifying the subsequent charging station of the one or more charging stations within the predefined distance of the vehicle. The non-transitory computer readable storage medium then causes communicating a second status inquiry to the subsequent charging station. The non-transitory computer readable storage medium then causes receiving a second message comprising at least one of a second operational status and a second occupancy status of the subsequent charging station in response to the second status inquiry. The non-transitory computer readable storage medium then determines that the subsequent charging station is available for charging the vehicle when the second operational status and the second occupancy status is received as available.

In one embodiment, determining the subsequent charging station and providing the one or more second routes to the subsequent charging station onto the display further causes the following technical steps to be executed. The non-transitory computer readable storage medium causes retrieving a real-time location of the subsequent charging station from a database; identifying the one or more second routes that lead to the real-time location of the subsequent charging station from the real-time location of the vehicle. The non-transitory computer readable storage medium then causes providing the one or more second routes to the subsequent charging station onto the display.

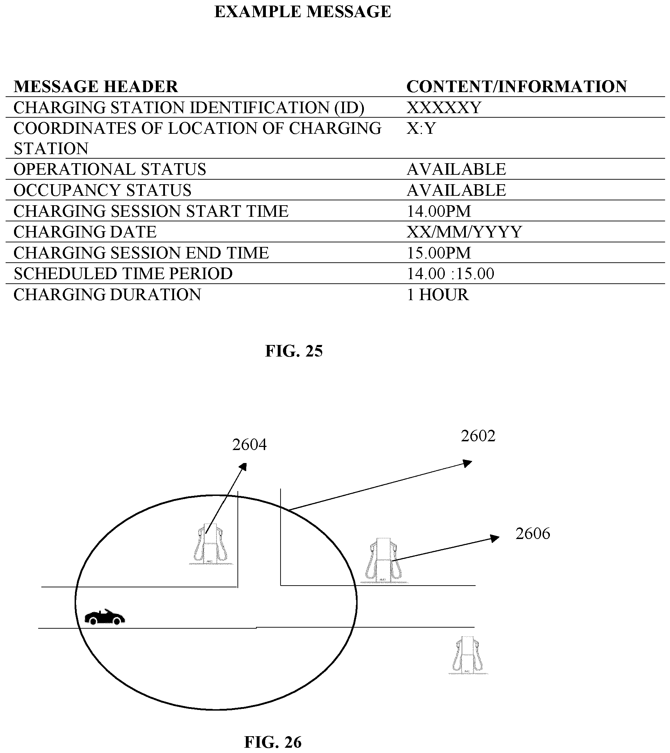

As an example, FIG. 25 illustrates a first message described in FIG. 22, according to one or more embodiments. The first message comprises one of a charging station identification number, coordinates of a location of the charging station, an operational status, an occupancy status, a charging date, a charging session start time, a charging session end time, a scheduled time period, and a charging duration.

The charging station identification number may be a serial identification number, or a tag associated with the charging station configured to identify, recognize, and locate the charging station. The coordinates of the location of the charging station indicate the location of the charging station. The charging date indicates a date on which the charging session is scheduled. The charging session start time indicates a time at which the charging session is to be initiated. The charging session end time indicates a time at which the charging session is to be ended/completed. The scheduled time period indicates a range of start time to end time of the charging session. The charging duration refers to total time for which the charging session is scheduled. The operational status may be one of "available" and "occupied". The operational status is indicated as "occupied" when the charging station is in the operation of charging another vehicle. The operational status may also be indicated as "occupied" when there is no charging session for the vehicle reserved with the charging station. The operational status is indicated as "available" when the charging station is ready for charging a vehicle. The operational status may also be indicated as "available" when there is a charging session for the vehicle reserved with the charging station. The occupancy status may be one of "available" and "occupied". The occupancy status is indicated as "occupied" when there is another vehicle blocking or obstructing the charging station. The occupancy status may also be indicated as "occupied" when there is no charging session for the vehicle reserved with the charging station. The occupancy status is indicated as "available" when there is not any other vehicle blocking or obstructing the charging station. The occupancy status may also be indicated as "available" when there is a charging session for the vehicle reserved with the charging station.

**FIG. 26** illustrates determination of a subsequent charging station 2606, according to one or more embodiments. The processor monitors the one or more charging stations that are located within a predefined distance to a vehicle. The processor then determines whether the vehicle is in a predefined proximity 2602 to a reserved charging station 2604 of the one or more charging stations. Upon determining that the vehicle is in the predefined proximity 2602 to the reserved charging station 2604, the processor communicates a first status inquiry to the reserved charging station 2604. The processor then receives the first message comprising at least one of a first operational status and a first occupancy status of the reserved charging station 2604 in response to the first status inquiry. The processor provides one or more first routes to the reserved charging station 2604 onto a display when the first operational status and the first occupancy status is received as available. The processor determines a subsequent charging station 2606 and provides one or more second routes to the subsequent charging station 2606 onto the display when at least one of the first operational status and the first occupancy status is received as occupied.

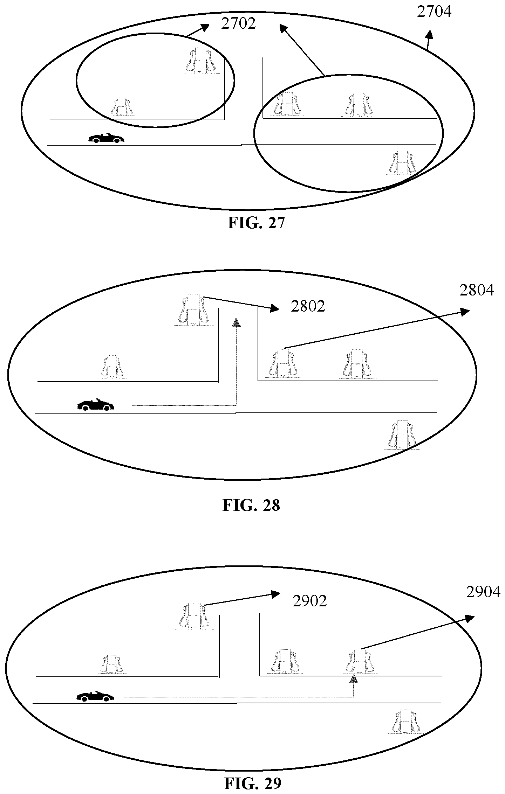

**FIG. 27** illustrates determination of one or more zones 2702 comprising charging stations, according to one or more embodiments. The processor identifies a real-time location of the vehicle using one or more sensors associated with the vehicle. The processor then determines, using an artificial intelligence engine, one or more zones 2702 comprising the one or more charging stations around the real-time location of the vehicle for the predefined distance. The processor then identifies the one or more charging stations that are located within the one or more zones within the predefined distance to the vehicle. The one or more zones 2702 may be grouped into a geographical range 2704. The one or more sensors may be associated with the vehicle, or with the one or more external infrastructures located along a route of the vehicle.

**FIG. 28** illustrates providing one or more routes 2806 to the reserved charging station 2802, according to one or more embodiments. The processor determines that the reserved charging station 2802 is available for charging the vehicle when the first operational status and the first occupancy status is received as available. The processor then determines a real-time location of the vehicle using one or more sensors associated with one of the vehicle, and one or more external infrastructures along a route of the vehicle. The processor then retrieves a real-time location of the reserved charging station 2802 from a database. The processor then identifies the one or more routes 2806 that lead to the real-time location of the reserved charging station 2802 from the real-time location of the vehicle. The processor then provides the one or more routes 2806 to the reserved charging station 2802 onto the display. The processor may determine a subsequent charging station 2804 when at least one of the first operational status and the first occupancy status of the reserved charging station 2802 is received as occupied.

**FIG. 29** illustrates providing one or more routes 2908 to the subsequent charging station 2904, according to one or more embodiments. The processor retrieves a real-time location of the subsequent charging station 2904 from a database when determining that the reserved charging station 2902 is unavailable for charging the vehicle. The processor then identifies the one or more routes 2908 that lead to the real-time location of the subsequent charging station 2904 from the real-time location of the vehicle. The processor then provides the one or more routes 2908 to the subsequent charging station 2904 onto the display.

In an embodiment of the system, the machine learning model is configured to learn using labelled data using a supervised learning method, wherein the supervised learning method comprises logic using at least one of a decision tree, a logistic regression, a support vector machine, a k-nearest neighbors, a Naive Bayes, a random forest, a linear regression, a polynomial regression, and a support vector machine for regression.

In an embodiment of the system, the machine learning model is configured to learn from the real-time data using an unsupervised learning method, the unsupervised learning method comprises logic using at least one of a k-means clustering, a hierarchical clustering, a hidden Markov model, and an apriori algorithm.

In an embodiment of the system, the machine learning model has a feedback loop, the output from a previous step is fed back to the model in real-time to improve the performance and accuracy of the output of a next step.

In an embodiment of the system, the machine learning model comprises a recurrent neural network model.

In an embodiment of the system, the machine learning model has a feedback loop, the learning is further reinforced with a reward for each true positive of the output of the system.

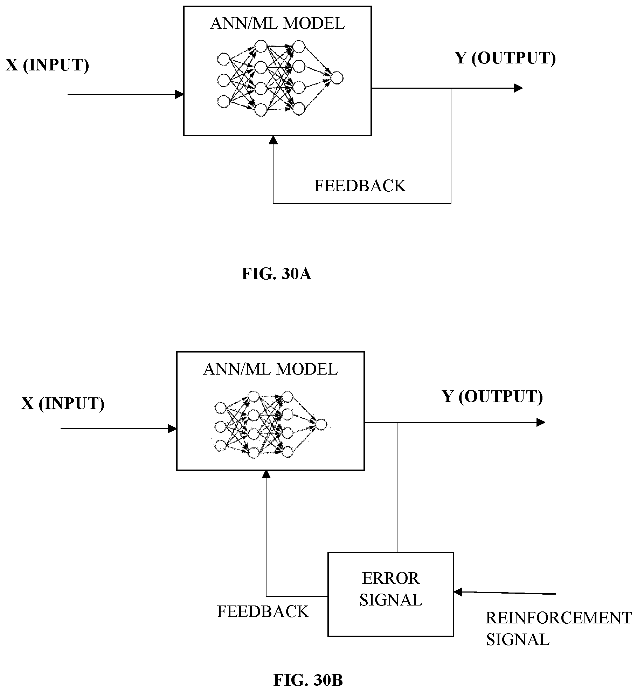

**FIG. 30A** shows a structure of the neural network / machine learning model with a feedback loop. Artificial neural networks (ANNs) model comprises an input layer, one or more hidden layers, and an output layer. Each node, or artificial neuron, connects to another and has an associated weight and threshold. If the output of any individual node is above the specified threshold value, that node is activated, sending data to the next layer of the network. Otherwise, no data is passed to the next layer of the network. A machine learning model or an ANN model may be trained on a set of data to take a request in the form of input data, make a prediction on that input data, and then provide a response. The model may learn from the data. Learning can be supervised learning and/or unsupervised learning and may be based on different scenarios and with different datasets. Supervised learning comprises logic using at least one of a decision tree, logistic regression, and support vector machines. Unsupervised learning comprises logic using at least one of a k-means clustering, a hierarchical clustering, a hidden Markov model, and an apriori algorithm. The output layer may predict or detect the first characteristics, the second characteristics, the tautness for the seat belt, the score, the convenience score, etc., based on the input data (explained above).

In an embodiment, ANNs may be a Deep-Neural Network (DNN), which is a multilayer tandem neural network comprising Artificial Neural Networks (ANN), Convolution Neural Networks (CNN) and Recurrent Neural Networks (RNN) that can recognize features from inputs, do an expert review, and perform actions that require predictions, creative thinking, and analytics. In an embodiment, ANNs may be Recurrent Neural Network (RNN), which is a type of Artificial Neural Networks (ANN), which uses sequential data or time series data. Deep learning algorithms are commonly used for ordinal or temporal problems, such as language translation, Natural Language Processing (NLP), speech recognition, and image recognition, etc. Like feedforward and convolutional neural networks (CNNs), recurrent neural networks utilize training data to learn. They are distinguished by their "memory" as they take information from prior input via a feedback loop to influence the current input and output. An output from the output layer in a neural network model is fed back to the model through the feedback. The variations of weights in the hidden layer(s) will be adjusted to fit the expected outputs better while training the model. This will allow the model to provide results with far fewer mistakes.

The neural network is featured with the feedback loop to adjust the system output dynamically as it learns from the new data. In machine learning, backpropagation and feedback loops are used to train an AI model and continuously improve it upon usage. As the incoming data that the model receives increases, there are more opportunities for the model to learn from the data. The feedback loops, or backpropagation algorithms, identify inconsistencies and feed the corrected information back into the model as an input.

Even though the AI/ML model is trained well, with large sets of labelled data and concepts, after a while, the models' performance may decline while adding new, unlabelled input due to many reasons which include, but not limited to, concept drift, recall precision degradation due to drifting away from true positives, and data drift over time. A feedback loop to the model keeps the AI results accurate and ensures that the model maintains its performance and improvement, even when new unlabelled data is assimilated. A feedback loop refers to the process by which an AI model's predicted output is reused to train new versions of the model.

Initially, when the AI/ML model is trained, a few labelled samples comprising both positive and negative examples of the concepts (for e.g., seat belt tautness) are used that are meant for the model to learn. Afterward, the model is tested using unlabelled data. By using, for example, deep learning and neural networks, the model can then make predictions on whether the desired concept/s (for e.g., tautness, convenience score, score, to be detected) are in unlabelled images. Each image is given a probability score where higher scores represent a higher level of confidence in the models' predictions. Where a model gives an image a high probability score, it is auto labelled with the predicted concept. However, in the cases where the model returns a low probability score, this input may be sent to a controller (may be a human moderator) which verifies and, as necessary, corrects the result. The human moderator may be used only in exceptional cases. The feedback loop feeds labelled data, auto-labelled or controller-verified, back to the model dynamically and is used as training data so that the system can improve its predictions in real-time and dynamically.

**FIG. 30B** shows a structure of the neural network / machine learning model with reinforcement learning. The network receives feedback from authorized networked environments. Though the system is similar to supervised learning, the feedback obtained in this case is evaluative not instructive, which means there is no teacher as in supervised learning. After receiving the feedback, the network performs adjustments of the weights to get better predictions in the future. Machine learning techniques, like deep learning, allow models to take labelled training data and learn to recognize those concepts in subsequent data and images. The model may be fed with new data for testing, hence by feeding the model with data it has already predicted over, the training gets reinforced. If the machine learning model has a feedback loop, the learning is further reinforced with a reward for each true positive of the output of the system. Feedback loops ensure that AI results do not stagnate. By incorporating a feedback loop, the model output keeps improving dynamically and over usage/time.

In an embodiment, the system further comprises a cyber security module, the cyber security module comprises an information security management module providing isolation between the communication module and servers.

In an embodiment, the information security management module is operable to: receive data from the communication module, exchange a security key at a start of the communication between the communication module and the server, receive the security key from the server, authenticate an identity of the server by verifying the security key, analyze the security key for a potential cyber security threat, negotiate an encryption key between the communication module and the server, encrypt the data, and transmit the encrypted data to the server when no cyber security threat is detected.

In an embodiment, the information security management module is operable to exchange a security key at a start of the communication between the communication module and the server, receive the security key from the server, authenticate an identity of the server by verifying the security key, analyze the security key for a potential cyber security threat, negotiate an encryption key between the system and the server, receive encrypted data from the server, decrypt the encrypted data, perform an integrity check of the decrypted data, and transmit the decrypted data to the communication module when no cyber security threat is detected.

In an embodiment, the system may comprise a cyber security module.

In one aspect, a secure communication management (SCM) computer device for providing secure data connections is provided. The SCM computer device includes a processor in communication with memory. The processor is programmed to receive, from a first device, a first data message. The first data message is in a standardized data format. The processor is also programmed to analyze the first data message for potential cyber security threats. If the determination is that the first data message does not contain a cyber security threat, the processor is further programmed to convert the first data message into a first data format associated with the vehicle environment and transmit the converted first data message to the vehicle system using a first communication protocol associated with the vehicle system.

According to an embodiment, secure authentication for data transmissions comprises, provisioning a hardware-based security engine (HSE) located in communications system, said HSE having been manufactured in a secure environment and certified in said secure environment as part of an approved network; performing asynchronous authentication, validation and encryption of data using said HSE, storing user permissions data and connection status data in an access control list used to define allowable data communications paths of said approved network, enabling communications of the communications system with other computing system subjects to said access control list, performing asynchronous validation and encryption of data using security engine including identifying a user device (UD) that incorporates credentials embodied in hardware using a hardware-based module provisioned with one or more security aspects for securing the system, wherein security aspects comprising said hardware-based module communicating with a user of said user device and said HSE.

In an embodiment, the system comprises a cyber security module. The components of the cyber security module are described below. The communication of data between the system and the server through the communication module is first verified by the information security management module before being transmitted from the system to the server or from the server to the system. The information security management module is operable to analyze the data for potential cyber security threats, to encrypt the data when no cyber security threat is detected, and to transmit the data encrypted to the system or the server.

In an embodiment, the cyber security module further comprises an information security management module providing isolation between the system and the server. The cyber security module secures the data through executing the following technical steps. The information security management module is operable to receive data from the communication module. The information security management module exchanges a security key at a start of the communication between the communication module and the server. The information security management module receives a security key from the server. The information security management module authenticates an identity of the server by verifying the security key. The information security management module analyzes the security key for potential cyber security threats. The information security management module negotiates an encryption key between the communication module and the server. The information security management module receives the encrypted data. The information security management module transmits the encrypted data to the server when no cyber security threat is detected.

In an embodiment, the cyber security module secures the data through executing the following technical steps. The information security management module is operable to exchange a security key at a start of the communication between the communication module and the server. The information security management module receives a security key from the server. The information security management module authenticates an identity of the server by verifying the security key. The information security management module analyzes the security key for potential cyber security threats. The information security management module negotiates an encryption key between the communication module and the server. The information security management module receives encrypted data. The information security management module decrypts the encrypted data and performs an integrity check of the decrypted data. The information security management module transmits the decrypted data to the communication module when no cyber security threat is detected.

In an embodiment, the integrity check is a hash-signature verification using a Secure Hash Algorithm 256 (SHA256) or a similar method. In an embodiment, the information security management module is configured to perform asynchronous authentication and validation of the communication between the communication module and the server. In an embodiment, the information security management module is configured to raise an alarm if a cyber security threat is detected. In an embodiment, the information security management module is configured to discard the encrypted data received if the integrity check of the encrypted data fails. In an embodiment, the information security management module is configured to check the integrity of the decrypted data by checking accuracy, consistency, and any possible data loss during the communication through the communication module.

In an embodiment, the server is physically isolated from the system through the information security management module. When the system communicates with the server, identity authentication is first carried out on the system and the server. The system is responsible for communicating/exchanging a public key of the system and a signature of the public key with the server. The public key of the system and the signature of the public key are sent to the information security management module. The information security management module decrypts the signature and verifies whether the decrypted public key is consistent with the received original public key or not. If the decrypted public key is verified, the identity authentication is passed. Similarly, the system and the server carry out identity authentication on the information security management module. After the identity authentication is passed on to the information security management module, the two communication parties, the system, and the server, negotiate an encryption key and an integrity check key for data communication of the two communication parties through the authenticated asymmetric key. A session ID number is transmitted in the identity authentication process, so that the key needs to be bound with the session ID number; when the system sends data to the outside, the information security gateway receives the data through the communication module, performs integrity authentication on the data, then encrypts the data through a negotiated secret key, and finally transmits the data to the server through the communication module. When the information security management module receives data through the communication module, the data is decrypted first, integrity verification is carried out on the data after decryption, and if verification is passed, the data is sent out through the communication module; otherwise, the data is discarded. In an embodiment, the identity authentication is realized by adopting an asymmetric key with a signature.

In an embodiment, the signature is realized by a pair of asymmetric keys which are trusted by the information security management module and the system, wherein the private key is used for signing the identities of the two communication parties, and the public key is used for verifying that the identities of the two communication parties are signed. Signing identity comprises a public and a private key pair. In other words, signing identity is referred to as the common name of the certificates which are installed in the user's machine. In an embodiment, both communication parties need to authenticate their own identities through a pair of asymmetric keys, and a task in charge of communication with the information security management module of the system is identified by a unique pair of asymmetric keys. In an embodiment, the dynamic negotiation key is encrypted by adopting an Rivest-Shamir-Adleman (RSA) encryption algorithm. RSA is a public-key cryptosystem that is widely used for secure data transmission. The negotiated keys include a data encryption key and a data integrity check key. In an embodiment, the data encryption method is a Triple Data Encryption Algorithm (3DES) encryption algorithm. The integrity check algorithm is a Hash-based Message Authentication Code (HMAC-MD5-128) algorithm. When data is output, the integrity check calculation is carried out on the data, the calculated Message Authentication Code (MAC) value is added with the header of the value data message, then the data (including the MAC of the header) is encrypted by using a 3DES algorithm, the header information of a security layer is added after the data is encrypted, and then the data is sent to the next layer for processing. In an embodiment the next layer refers to a transport layer in the Transmission Control Protocol / Internet Protocol (TCP/IP) model.

The information security management module ensures the safety, reliability, and confidentiality of the communication between the system and the server through the identity authentication when the communication between the two communication parties starts the data encryption and the data integrity authentication. The method is particularly suitable for an embedded platform which has less resources and is not connected with a Public Key Infrastructure (PKI) system and can ensure that the safety of the data on the server cannot be compromised by a hacker attack under the condition of the Internet by ensuring the safety and reliability of the communication between the system and the server.

The embodiments described herein include mere examples of systems and computer-implemented methods. It is, of course, not possible to describe every conceivable combination of components and/or computer-implemented methods for purposes of describing the one or more embodiments, but one of ordinary skill in the art can recognize that many further combinations and/or permutations of the one or more embodiments are possible. Furthermore, to the extent that the terms "includes," "has," "possesses," and the like are used in the detailed description, claims, appendices and/or drawings such terms are intended to be inclusive in a manner similar to the term "comprising" as "comprising" is interpreted when employed as a transitional word in a claim.

Other specific forms may embody the present invention without departing from its spirit or characteristics. The described embodiments are in all respects illustrative and not restrictive. Therefore, the appended claims rather than the description herein indicate the scope of the invention. All variations which come within the meaning and range of equivalency of the claims are within their scope.

## Claims

1. A system comprising:
a sensor module; and
a control module that comprises:
a processor; and
a memory communicatively coupled to the processor, the memory comprising a sensor control module that when executed by the processor causes the processor to:
determine a first state-of-charge of one or more batteries associated with a vehicle;
determine whether the first state-of-charge is below a threshold charge level;
determine one or more first geographical ranges comprising one or more first charging stations based on the first state-of-charge;
determine one or more charge consumption factors that influence charge consumption in the one or more batteries;
estimate the charge consumption based on the one or more charge consumption factors;
determine a second state-of-charge based on the charge consumption;
determine one or more second geographical ranges comprising one or more second charging stations based on the second state-of-charge; and
reserve one or more charging sessions with the one or more second charging stations for charging the one or more batteries.

2. The system of claim 1, wherein the processor, determining the one or more first geographical ranges comprising the one or more first charging stations based on the first state-of-charge, is operable to:
determine, using an artificial intelligence engine, a distance range that the vehicle is capable to travel utilizing the first state-of-charge;
identify, using the artificial intelligence engine, one or more first zones, around the vehicle, comprising the one or more first charging stations that are available for charging;
determine, using the artificial intelligence engine, the one or more first geographical ranges encompassing the one or more first zones; and
provide, using the artificial intelligence engine, a layout of the one or more first geographical ranges.

3. The system of claim 2, wherein the processor, identifying, using the artificial intelligence engine, the one or more first zones, near the vehicle, comprising the one or more first charging stations that are available for charging, is operable to:
determine a real-time location of the vehicle;
determine the one or more first charging stations around the real-time location of the vehicle;
mapping the one or more first charging stations around the real-time location of the vehicle into the one or more first zones; and
marking the one or more first charging stations within the one or more first zones.

4. The system of claim 2, wherein the processor, determining the one or more charge consumption factors that influences the charge consumption in the one or more batteries, is operable to:
sense, using the sensor module, continuously at least one of one or more events, one or more activities, and one or more actions;
determine, using the artificial intelligence engine, the one or more charge consumption factors that lead to at least one of the one or more events, the one or more activities, and the one or more actions;
determine the charge consumption for at least one of the one or more events, the one or more activities, and the one or more actions; and
learn, using the artificial intelligence engine, the one or more charge consumption factors and the charge consumption.

5. The system of claim 4, wherein the one or more events comprises the vehicle travelling in an inclined surface for a predefined distance.

6. The system of claim 5, wherein the processor determines, using the artificial intelligence engine, a surface inclination as the one or more charge consumption factors that lead to the one or more events.

7. The system of claim 4, wherein the one or more events comprise the vehicle travelling with a predefined load.

8. A method comprising:
determining a first state-of-charge of one or more batteries associated with a vehicle;
determining whether the first state-of-charge is below a threshold charge level;
determining one or more first geographical ranges comprising one or more first charging stations based on the first state-of-charge;
determining one or more charge consumption factors that influences charge consumption in the one or more batteries;
estimating the charge consumption based on the one or more charge consumption factors;
determining a second state-of-charge based on the charge consumption;
determining one or more second geographical ranges comprising one or more second charging stations based on the second state-of-charge; and
reserving one or more charging sessions with the one or more second charging stations for charging the one or more batteries.

9. The method of claim 8, wherein determining the one or more first geographical ranges comprising the one or more first charging stations based on the first state-of-charge comprises:
determining, using an artificial intelligence engine, a distance range that the vehicle is capable to travel utilizing the first state-of-charge;
identifying, using the artificial intelligence engine, one or more first zones, around the vehicle, comprising the one or more first charging stations that are available for charging;
determining, using the artificial intelligence engine, the one or more first geographical ranges encompassing the one or more first zones; and
providing, using the artificial intelligence engine, a layout of the one or more first geographical ranges.

10. The method of claim 9, wherein identifying, using the artificial intelligence engine, the one or more first zones, near the vehicle, comprising the one or more first charging stations that are available for charging comprises:
determining a real-time location of the vehicle;
determining the one or more first charging stations around the real-time location of the vehicle;
mapping the one or more first charging stations around the real-time location of the vehicle into the one or more first zones; and
marking the one or more first charging stations within the one or more first zones.

11. The method of claim 8, wherein determining the one or more charge consumption factors that influences the charge consumption in the one or more batteries comprises:
sensing, using a sensor module, continuously one or more external charge consumption factors surrounding the vehicle;
determine at least one of a sudden change and an abnormal rise in charge consumption of the vehicle;
correlating at least one of the sudden change and the abnormal rise in the charge consumption to the one or more external charge consumption factors; and
learning, using an artificial intelligence engine, the one or more external charge consumption factors and the charge consumption based on the correlation.

12. The method of claim 8, wherein determining the one or more charge consumption factors that influences the charge consumption in the one or more batteries comprises:
sensing, using a sensor module, continuously one or more internal charge consumption factors;
determining at least one of a sudden change and an abnormal rise in charge consumption of the vehicle;
correlating at least one of the sudden change and the abnormal rise in the charge consumption to the one or more internal charge consumption factors; and
learning, using an artificial intelligence engine, the one or more internal charge consumption factors and the charge consumption based on the correlation.

13. A non-transitory computer readable storage medium, comprising a sequence of instructions, which when executed by a processor causes:
determining a first state-of-charge of one or more batteries associated with a vehicle;
determining whether the first state-of-charge is below a threshold charge level;
determining one or more first geographical ranges comprising one or more first charging stations based on the first state-of-charge;
determining one or more charge consumption factors that influences charge consumption in the one or more batteries;
estimating the charge consumption based on the one or more charge consumption factors;
determining a second state-of-charge based on the charge consumption;
determining one or more second geographical ranges comprising one or more second charging stations based on the second state-of-charge; and
reserving one or more charging sessions with the one or more second charging stations for charging the one or more batteries.

14. The non-transitory computer readable storage medium of claim 13, wherein determining the one or more second geographical ranges comprising the one or more second charging stations based on the second state-of-charge comprises:
determining, using an artificial intelligence engine, a distance range that the vehicle is capable to travel utilizing the second state-of-charge;
identifying, using the artificial intelligence engine, one or more second zones, around the vehicle, comprising the one or more second charging stations that are available for charging;
determining, using the artificial intelligence engine, the one or more second geographical ranges encompassing the one or more second zones; and
providing, using the artificial intelligence engine, a layout of the one or more second geographical ranges.

15. The non-transitory computer readable storage medium of claim 14, wherein reserving the one or more second charging stations for charging the one or more batteries comprises:
determining a time of arrival of the vehicle at a location of the one or more second charging stations;
determining a charging duration for the one or more batteries to complete the charging;
determining a time left for the vehicle based on an itinerary associated with a user of the vehicle;
computing the one or more charging sessions, using an artificial intelligence engine, based on at least one of the time of arrival, the charging duration, and the time left; and
compiling one or more messages to the one or more second charging stations based on the one or more charging sessions.
